# EUROPEAN PATENT APPLICATION

(11) **EP 2 505 694 A2**
(43) Date of publication of application: **03.10.2012**
(21) Application number: 12174244.9
(22) Date of filing: 09.10.2003
(51) Int. Cl.: C30B 1/02

(54) **Method for solid-sate single crystal growth**

(30) Priority: 11.10.2002 KR 20020062033; 08.10.2003 KR 20030069867
(62) Divisional of application: 03751495.7
(71) Applicant: Ceracomp Co., Ltd., Asan-city, Choongchungnam-do 336-840 (KR)
(72) Inventor: Lee, Ho-Yong, Seoul 135-110 (KR); Lee, Jong-Bong, Chunan-city 330-823 (KR); Hur, Tae-Moo, 459-813 Pyeongtaek-city (KR); Kim, Dong-Ho, Seoul Seoul (KR)
(74) Representative: Novagraaf Technologies

(57) **Abstract**

The invention relates to a method for growing single crystals in polycrystalline bodies in which abnormal grain growth occurs. The method is characterized by controlling the average size of matrix grains of polycrystalline bodies in which abnormal grain growth occurs, whereby reducing the number density (number of abnormal grains/unit volume) of abnormal grains to generate only a extremely limited number of abnormal grains or inhibit the generation of abnormal grains within the extent of guaranteeing the driving force of abnormal grain growth. Therefore, the invention grows continuously only the extremely limited number of abnormal grains or only the seed single crystal into the polycrystalline body to obtain a large single crystal having a size larger than 50mm.

## Description

### BACKGROUND OF THE INVENTION

### 1. Field of the Invention

The present invention relates to a method for growing single crystals, and more particularly to a method for growing single crystals by controlling the average size of matrix grains of polycrystalline bodies to be near a critical size at which an abnormal, exaggerated or discontinuous grain growth starts to occur, thereby reducing a number density of the abnormal grains.

### 2. Background of the Related Art

The single crystals are generally manufactured by using a melting process. Accordingly, a general method for single crystal growth using the melting process is referred to as a Liquid-State Single Crystal Growth (LSCG) method. However, contrary to the general liquid-state single crystal growth method, a method for producing the single crystals by using a grain growth of matrix grains, which occurs during heat treatment of the polycrystalline bodies, without the melting process is referred to as a Solid-State Single Crystal Growth (SSCG) method. The grain growth always occurs during heat treatment of the polycrystalline bodies. In particular cases, an abnormal, exaggerated or discontinuous grain growth phenomenon which only abnormal grains are rapidly grown compared to most of normal or matrix grains occurs. If an extremely limited number of abnormal grains only are allowed to continue to be grown in the polycrystalline body by controlling the generation and growth of the abnormal grains, it is possible to produce the single crystals without the melting process, which is complex and difficult to be controlled. The SSCG method has been suggested since the 1950's and was successfully practiced in producing single crystals of a metal, which is limited only a few types. It is however reported that when the single crystals are produced by the grain growth in oxide materials, the method has a difficulty in manufacturing single crystals big enough for practical use from the oxide, because it is difficult to continuously grow only one single crystal in the polycrystalline body, that is, to control a number density of the abnormal grains.

Meanwhile, there has been made an attempt to obtain single crystals by heat-treating polycrystalline bodies of ferrite, barium titanate (BaTiO₃), aluminum oxide (Al₂O₃), PMN-PT, etc. through the solid-state single crystal growth method. This is a method for growing seed single crystals in polycrystalline bodies, which involves sintering powder-molded bodies impregnated with seed single crystals or forming an interface between the polycrystalline body and the seed single crystal, followed by heat treatment. However, the method is not suitable to preparing single crystals big enough for practical uses such as more than several tens mm because the growth of single crystals is retarded relative to the conventional liquid-state single crystal growth method which is practiced near the melting point, and it is difficult to continue to grow only one single crystal. Even though single crystals were produced by using abnormal grain growth phenomenon occurring in the polycrystalline bodies, single crystals big enough for practical uses such as more than several tens mm could not be grown because it was impossible to control a number density of the abnormal grains, and thus to generate and continue to grow only one single crystal in the polycrystalline bodies. Even though single crystals were produced by using the seed single crystals in the polycrystalline bodies in which the abnormal grain growth occurs, it was difficult to continue to grow the seed single crystals because it was impossible to control the number density of the abnormal grains, so that the abnormal grains generated in the polycrystalline bodies repressed the growth of the seed single crystals. Therefore, the conventional solid-state single crystal growth method was less advantageous than the conventional liquid-state single crystal growth method, in that it was difficult to produce single crystals having an actually applicable big size and the reproduction possibility was low because it was impossible to control the number density of the abnormal grains.

The conventional methods for growing single crystals, however, involve many problems in producing a large amount of big single crystals because of the requirement of expensive facilities and extremely complicated process for growing the single crystals and have difficulty in the application because of the high expense. In particular, the materials comprising a component having a strong volatility have serious problems because the component volatilize when single crystals are grown. Further, the conventional methods for growing single crystals necessarily require a melting process, and thus make the entire composition be changed and the phase of the single crystal unstable due to the volatilization of the component having a strong volatility during the melting process. Therefore, it is difficult to produce a single crystal having a desired size and properties. In addition, it is difficult to produce the single crystals in large quantities because of the difficulty in the production processes and the requirement of expensive facilities.

### SUMMARY OF THE INVENTION

Accordingly, the present invention has been made to solve the above-mentioned problems occurring in the prior art. The obj ect of the present invention is to overcome the problems of the conventional single crystal growth method (i.e., liquid-state single crystal growth method) requiring a melting process, and to provide a method for growing single crystals of undoped barium titanate (BaTiO₃), barium titanate solid solution ((BaₓM₁₋ₓ)(TiyN_{1-y})O₃) (0≤x≤1; 0≤y≤1), various compositional materials, including Pb-type perovskite such as PbTiO₃(PT), Pb(ZrₓTi₁₋ₓ)O₃ [PZT], (1-*x*)Pb(Mg_{1/3}Nb_{2/3})O₃-xPbTiO₃ [(1-*x*)PMN-*x*PT], (1-*x*-*y*)Pb(Mg_{1/3}Nb_{2/3})O₃-xPbTiO₃-yPbZrO₃ [(1-*x*-*y*)PMN-*x*PT-*y*PZ], (1-*x*-*y*)Pb(Yb_{1/2}Nb_{1/2})O₃-*x*PbTiO₃-*y*PbZrO₃ [(1-*x-y*)PYbN-xPT-*y*PZ], (1-*x*-*y*)Pb(In_{1/2}Nb_{1/2})O₃-*x*PbTiO₃-*y*PbZrO₃ [(1-*x*-*y*)PIN-*x*PT-*y*PZ], (1-*x*-*y*)PYbN-*x*PMN-*y*PT and (1-*x*-*y*)PIN-*x*PMN-*y*PT (0≤x≤1; 0≤y≤1; 0≤x+y≤1) and Pb-type perovskite solid solution through Solid-State Single Crystal Growth(SSCG), by effectively controlling abnormal grain growth occurring in polycrystalline bodies only through a general heat treatment process without using a melting process and a special apparatus, thereby allowing the mass production of single crystals at low costs with high reproduction possibility.

In order to achieve these objects, according to the invention, there is provided a method for growing single crystals of materials, which show abnormal grain growth by means of heat treatment, the method comprising the steps of (a) controlling an average size of matrix grains of a polycrystalline body of the materials in which abnormal grain growth occurs, thereby reducing a number density of abnormal grains (number of abnormal grains/unit area); and (b) heat-treating the polycrystalline body having reduced number density of abnormal grains through the step (a), thereby growing the abnormal grains.

Further, according to the invention, there is provided a method for growing single crystals of materials, which show abnormal grain growths by means of heat treatment, the method comprising the step of heat treating polycrystalline body under the condition of reducing a number density of abnormal grains (number of abnormal grains/unit area) by controlling an average size of matrix grains of polycrystalline body.

According to the invention, the single crystals are obtained by continuously growing only a limited number of abnormal grains produced under the state that the number density of abnormal grains is reduced.

According to the invention, the method further comprises the steps of: prior to the heat treatment, adjoining a seed single crystal to a polycrystalline body, and then heat-treating the combination of the seed single crystal and the polycrystalline body under the condition that abnormal grain growth is induced at the interface between the polycrystalline body and the seed single crystal and repressed inside the polycrystalline body, thereby continuously growing the seed single crystal into the polycrystalline body.

According to the invention, the average size (R) of matrix grains of the polycrystalline body is controlled to be within a range between 0.5R_{c} and 2R_{c} (i.e., 0.5R_{c} ≤ R ≤ 2R_{c}), R_{c} (an average size of the matrix grains at which the number density of abnormal grains becomes 'zero') being a critical size at which nucleation of abnormal grains starts to occur.

According to the invention, when it is desired to generate and grow only a limited number of abnormal grains, the average size (R) of matrix grains of the polycrystalline body is controlled to be within a range between 0.5R_{c} and R_{c} (i.e., 0.5(R_{c} ≤ R≤ R_{c}), Rc (an average size of the matrix grains at which the number density of abnormal grains becomes 'zero') being a critical size at which nucleation of abnormal grains starts to occur.

According to the invention, the abnormal grain growth is, preferably, a secondary abnormal grain growth.

### BRIEF DESCRIPTION OF THE DRAWINGS

The above and other objects, features and advantages of the present invention will be more apparent from the following detailed description taken in conjunction with the accompanying drawings, in which:

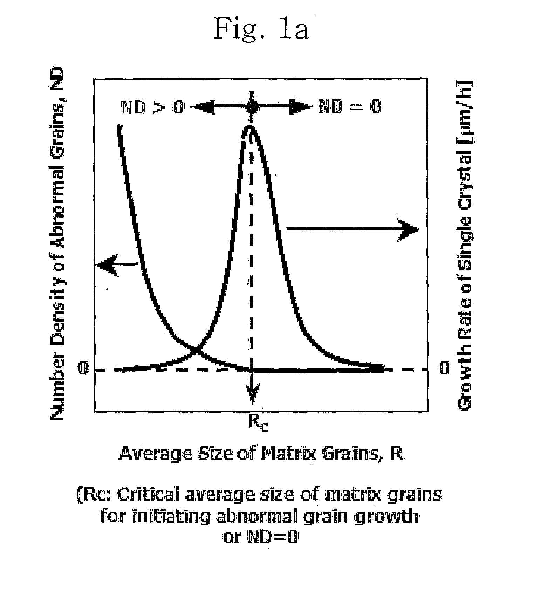

FIG. 1a is a graph showing correlations between an average size (R) of matrix grains of polycrystalline body and a number density (ND) of the abnormal grains (number of abnormal grains / unit area), and between the average size (R) of matrix grains and a growth rate of a single crystal in the polycrystalline body in which abnormal grain growth occurs in the invention;

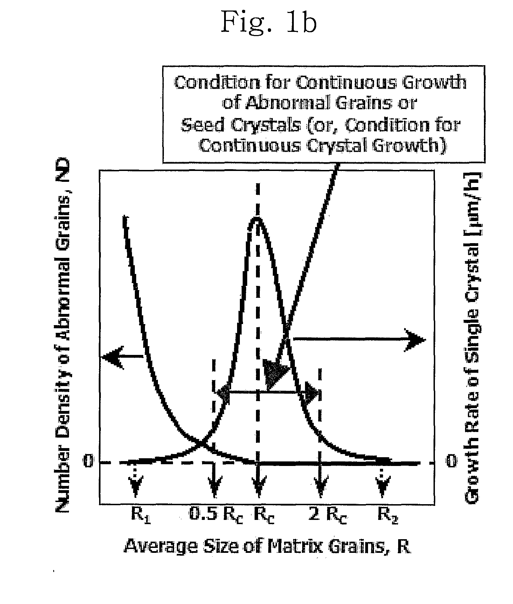

FIG. 1b is a graph showing a continuous growth condition of a seed single crystal (0.5R_{c} ≤ R≤ 2R_{c}) where R is the average size of matrix grains and R_{c} is a critical size of matrix grains for initiating an abnormal grain growth);

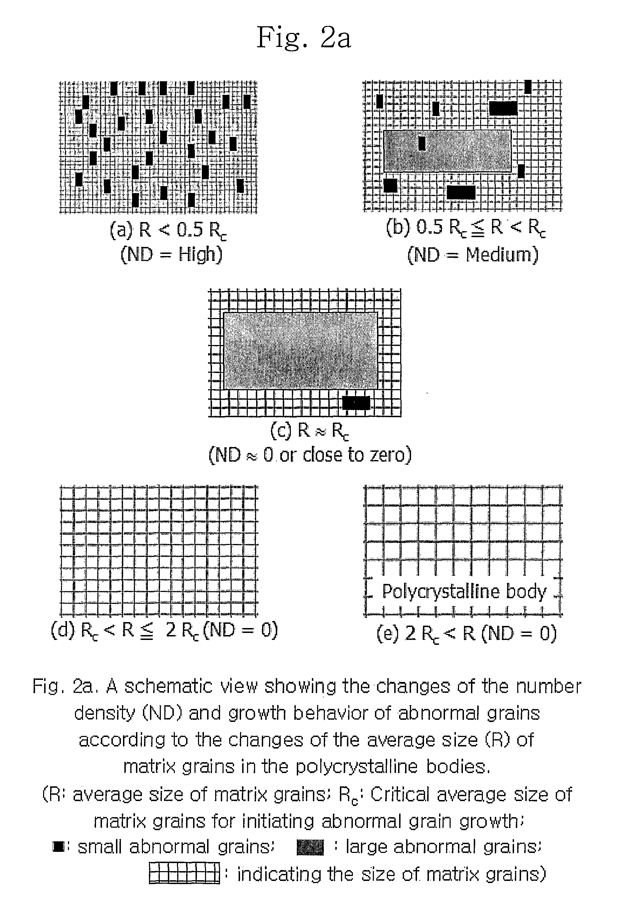

FIG. 2a is a schematic view showing the changes of the number density of abnormal grains and a degree of the abnormal grain growth according to the changes of the average size of matrix grains in the polycrystalline body (the condition for the continuous growth of abnormal grains is 0.5R_{c} ≤ R≤ R_{c}) in the invention;

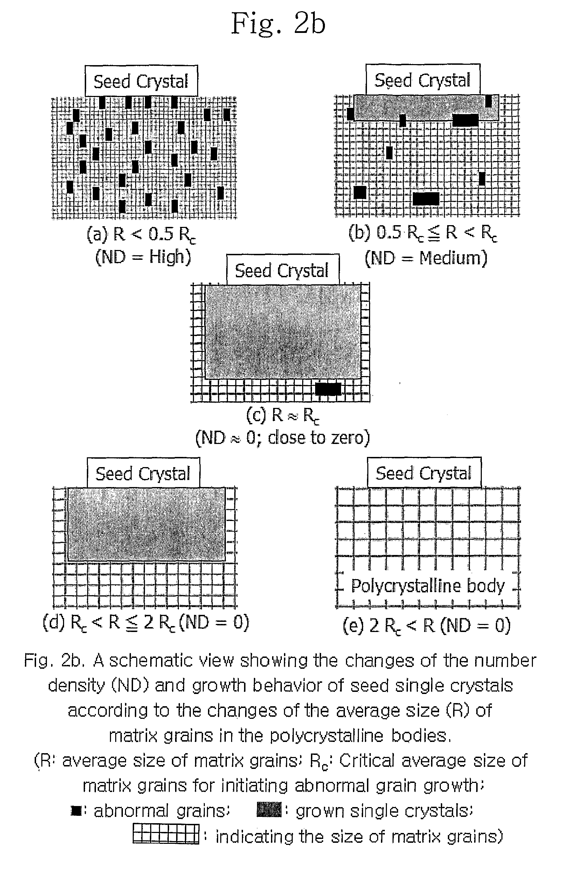

FIG. 2b is a schematic view showing the changes of the number density of abnormal grains and the degree of the seed single grain growth according to the changes of the average size of matrix grains in the polycrystalline body (the condition for the continuous growth of the seed single crystal is 0.5R_{c} ≤ R≤ 2R_{c}) in the invention;

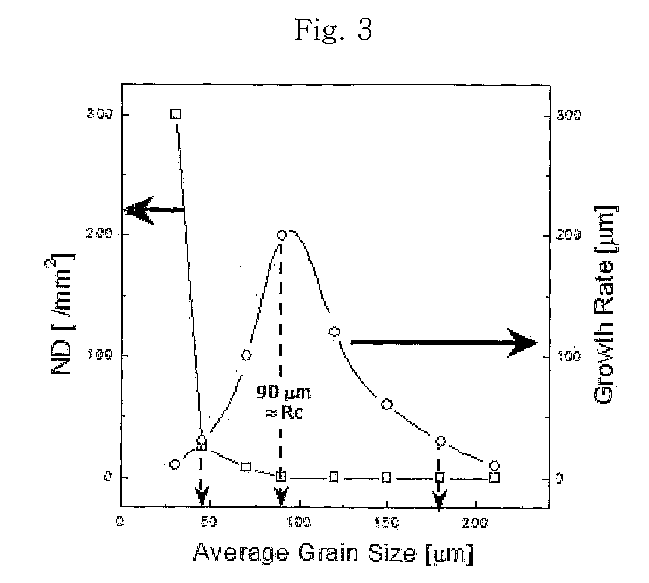

FIG. 3 is a graph showing the correlations between the average size (R) of matrix grains and the number density (ND) of abnormal grains generated in the polycrystalline body, and between the average size (R) of matrix grains and a growth rate of the seed single crystal into the polycrystalline body, in a sample prepared by heat treating Ba(Ti_{0.7}Zr_{0.3})O₃ polycrystalline body [(100-x) Ba(Ti_{0.7}Zr_{0.3})O₃-*x*TiO₂ (0≤*x*≤1)] at 1380°C for 15 hours;

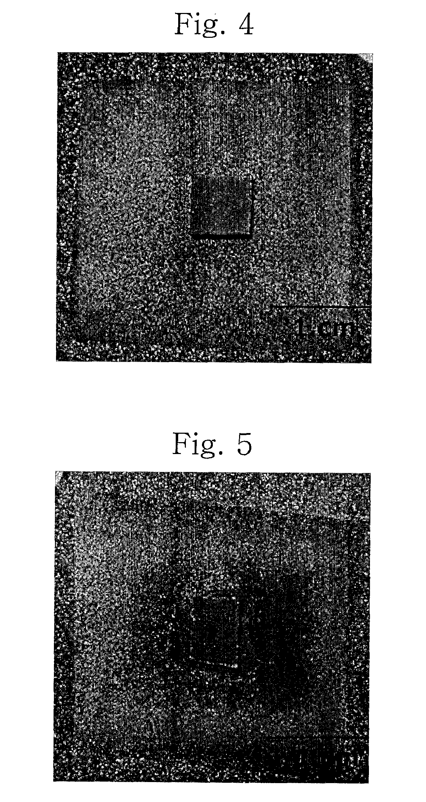

FIG. 4 is a photograph showing a single crystal grown from a sample obtained by placing a seed single crystal having the composition formula of Ba(Ti_{0.7}Zr_{0.3})O₃ on a polycrystalline body having the composition formula of (99.6)Ba(Ti_{0.7}Zr_{0.3})O₃-(0.4)TiO₂ [mol%], and then heat-treating the combination of the seed single crystal and the polycrystalline body at 1380°C for 200 hours.
FIG. 5 is a photograph showing a sample obtained by sintering a polycrystalline body having the composition formula of (99.2)Ba(Ti_{0.7}Zr_{0.3})O₃-(0.8)TiO₂ at 1380°C for 5 hours in the reductive atmosphere of oxygen partial pressure (Pₒ₂) of 0.01 or less, placing a seed single crystal of Ba(Ti_{0.7}Zr_{0.3})O₃ on the sintered polycrystalline body, and then heat-treating the combination of the seed single crystal and the sintered polycrystalline body at 1380°C for 200 hours in the air atmosphere;

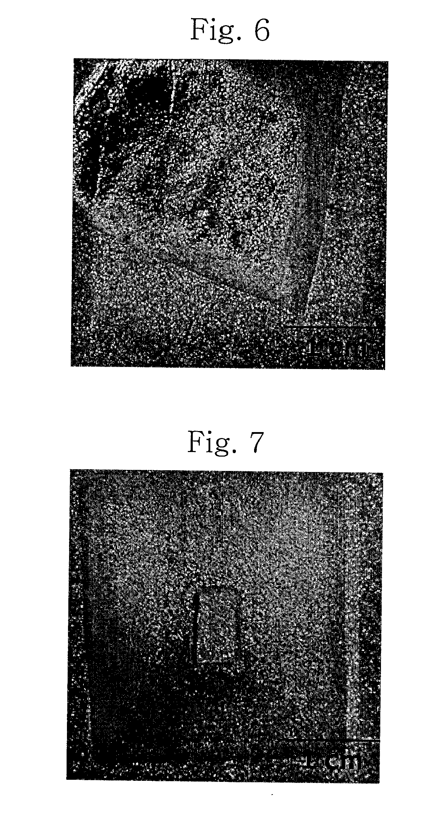

FIG. 6 is a photograph showing a single crystal of Ba(Ti_{0.95}Zr_{0.05})O₃ grown from a sample obtained by heat-treating powder-molded body having the composition formula of (99.8)Ba(Ti_{0.95}Zr_{0.05})O₃-(0.2)TiO₂ at 1370°C for 200 hours in the air.
FIG. 7 is a photograph showing a sample obtained by primarily sintering the powder-molded body having the composition formula of (99.8)Ba(Ti_{0.95}Zr_{0.05})O₃-(0.2)TiO₂ at 1390°C for 5 hours in the air, placing a single crystal of Ba(Ti_{0.95}Zr_{0.05})O₃ on the primarily sintered body, and then heat-treating the combination at 1370°C for 200 hours in the air;

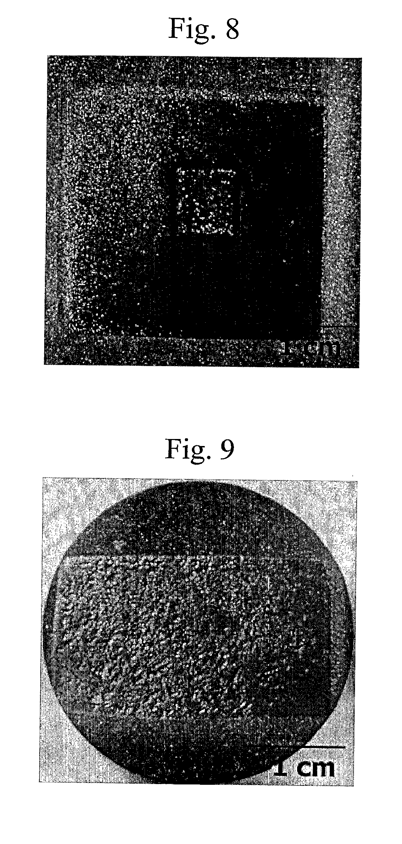

FIG. 8 is a photograph showing a single crystal grown from a sample obtained by placing a seed single crystal of barium titanate on the powder-molded body having the composition formula of (99.6)BaTiO₃-(0.4)ZrO₂, and then heat-treating the combination at 1380°C for 200 hours;
FIG. 9 is a photograph showing a surface of a 68PMN-32PT single crystal grown from a sample obtained by embedding a seed single crystal of barium titanate in a powder-molded body having the composition formula of (90)[(68)[Pb(Mg_{1/3}Nb_{2/3})O₃]-(32)[PbTiO₃]]-(10)PbO [mol%], and then heat-treating the combination at 1200°C for 100 hours;

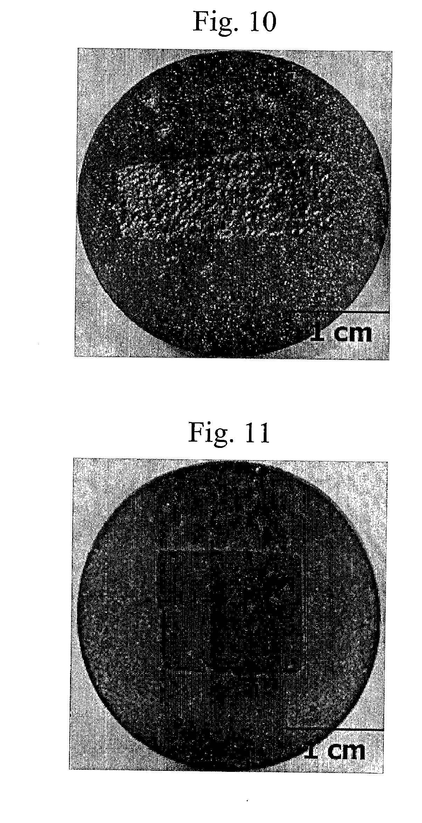

FIG. 10 is a photograph showing a surface of a PZT single crystal grown from a sample obtained by embedding a single crystal of Ba(Ti_{0.7}Zr_{0.3})O₃ in a powder-molded body having the composition formula of (90)[Pb(Zr_{0.46}Ti_{0.54})O₃]-(10)PbO, and then heat-treating the combination at 1200°C for 100 hours;
FIG. 11 is a photograph showing a surface of a sample obtained by embedding a seed single crystal of Ba(Ti_{0.95}Zr_{0.o05})O₃ in a powder-molded body having the composition formula of (91)[(50)[Pb(Mg_{1/3}Nb_{2/3})O₃]-(36)[PbTiO₃]-(14)[PbZrO₃]]-(9)PbO [mol%], and then heat-treating the combination at 1200°C for 100 hours;

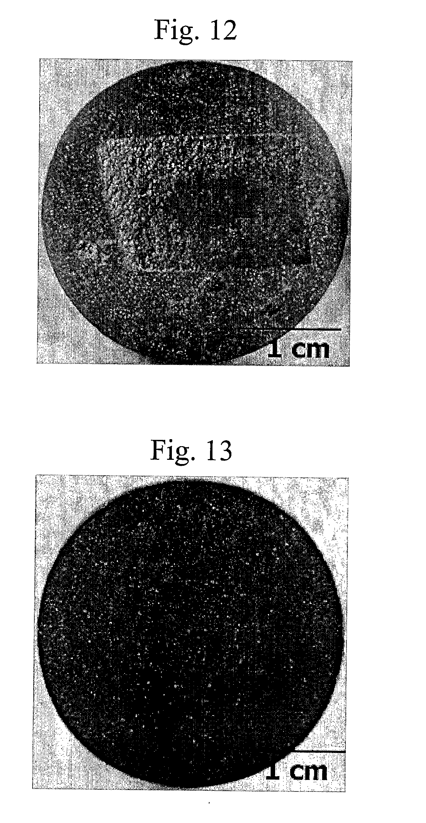

FIG. 12 is a photograph showing a surface of a sample obtained by embedding a seed single crystal of Ba(Ti_{0.95}Zr_{0.05})O₃ in a powder-molded body having the composition formula of (92)[(50)[Pb(Yb_{1/2}Nb_{1/2})O₃]-(36)[PbTiO₃]-(14)[PbZrO₃]]-(8)PbO [mol%], and then heat-treating the combination at 1150°C for 100 hours;
FIG. 13 is a photograph showing a surface of a sample obtained by embedding a seed single crystal of Ba(Ti_{0.95}Zr_{0.05})O₃ in a powder-molded body having the composition formula of (91)[(20)[Pb(In_{1/2}Nb_{1/2})O₃]-(48)[Pb(Mg_{1/3}Nb_{2/3})O₃]-(32)[PbTiO₃]]-(9)PbO [mol%], and then heat-treating the combination at 1200°C for 100 hours;

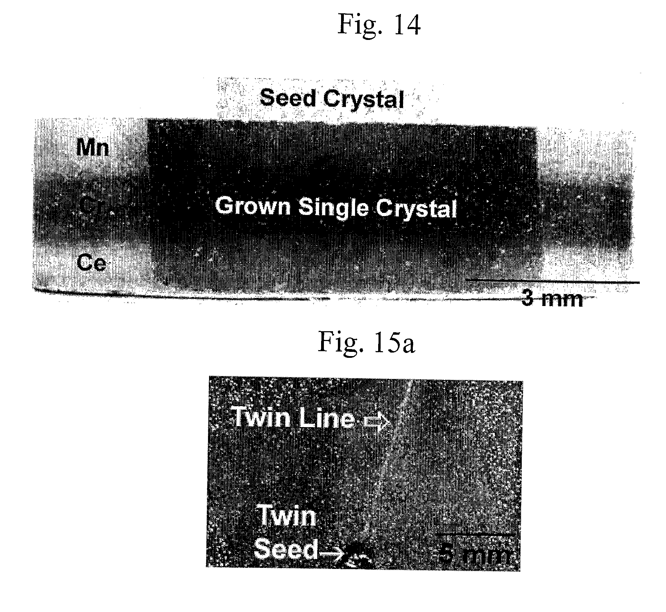

FIG. 14 is a photograph showing a cross-section of a sample obtained by depositing powders having the composition formulas of (99.8)BaTiO₃-(0.2)MnO₂, (99.8)BaTiO₃-(0.2)NbO_{2.5} and (99.8)BaTiO₃-(0.2)CeO₂ [mol%] in regular order, primarily sintering the powder-molded body at 1370°C for 5 hours in the atmosphere of oxygen partial pressure (Pₒ₂) of 0.01, placing a seed single crystal of barium titanate on the sintered body, and then heat-treating the combination of the seed single crystal and the sintered body at 1370°C for 100 hours in the atmosphere of oxygen partial pressure of 0.2; and

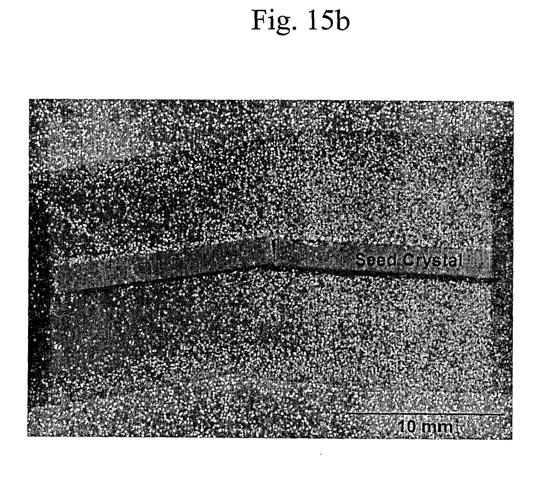

FIGs. 15a and 15b are photographs showing samples obtained by placing (a) a single crystal of barium titanate comprising a (111) double twin and (b) two rod-type single crystals of barium titanate which were turned by an angle of about 10° after separating one rod single crystal into two single crystals, on a powder-molded body having the composition formula of (99.6)BaTiO₃-(0.4)ZrO₂, and then heat-treating the combination at 1380°C for 200 hours.

### DETAILED DESCRIPTION OF THE PREFERRED EMBODIMENTS

Hereinafter, preferred embodiments of a solid-state single crystal growth method according to the present invention will be described in more details with reference to the accompanying drawings.

A number density (ND) of abnormal grains (number of abnormal grains per unit area) is inversely proportional to an average size (R) of matrix grains of a polycrystalline body, and in particular, becomes to "zero" beyond a critical average size of matrix grains for abnormal grain growth, so that the abnormal grain growth is totally repressed. Based on this phenomenon, this method for growing single crystals of materials, which show abnormal grain growths by means of heat-treating, involves controlling the average size (R) of matrix grains of a polycrystalline body to be within a particular range of 0.5R_{c} ≤ R ≤ 2R_{c} (R_{c} : the critical size of matrix grains at which abnormal grain generation occurs). The single crystals can be obtained by carrying out the heat treatment under the condition of controlling the number density of abnormal grains, or heat-treating polycrystalline bodies having the controlled number density. The single crystal can be obtained by continuing to grow only a limited number of abnormal grains generated under the state of controlling the number density of abnormal grains. Further, a seed single crystal continues to be grown into the polycrystalline body with the same growth mechanism as the abnormal grain growth of the polycrystalline body by adjoining a seed single crystal to a polycrystalline body in which a generation of abnormal grains is totally repressed or adjoining the seed single crystal to a polycrystalline body under the condition of controlling the number density of abnormal grains, and then heat-treating the combination. In this case, the heat treatment is carried out under the condition that abnormal grain growth is induced at the interface between the polycrystalline body and the seed single crystal and repressed inside the polycrystalline body. When the average size of matrix grains of the polycrystalline body is smaller than 0.5R_{c}, it is difficult to grow a big single crystal because the number density of abnormal grains is too high and thus the single crystal collides with the abnormal grains. Also, when the average size of matrix grains is larger than 2R_{c}, it is difficult to grow a big single crystal because a growth rate of the single crystal is too slow.

There are various methods of controlling the average size of matrix grains of the polycrystalline body. Firstly, the size of matrix grains can be controlled by adding one or more specific components among components of matrix grains of the polycrystalline body so that the polycrystalline body contains the specific components in an amount higher or lower than its content in the original composition of the polycrystalline body. For example, the size of matrix grains can be reduced by adding excess TiO₂ to Ba(Ti,Zr)O₃ ceramics. In addition, the size of matrix grains can be controlled as desired by changing a ratio of components of matrix grains of polycrystalline body or adding one or more additives different from the components of matrix grains of polycrystalline body to the polycrystalline body. Additionally, the average size of matrix grains of polycrystalline body can be controlled by pre-heat treating the polycrystalline body at the temperatures higher than the heat treatment temperature for abnormal grain growth or using a sintering atmosphere different from a sintering atmosphere for abnormal grain growth. The average size can be also controlled by controlling a density of the polycrystalline body or a pressure during pressure sintering. There is also a method that the average size of matrix grains of polycrystalline body is increased by repeatedly inducing the abnormal grain growths in the polycrystalline body.

The abnormal grain growth of a polycrystalline body comprises a primary abnormal grain growth and a secondary abnormal grain growth. In the same material, the primary abnormal grain growth occurs antecedently to the secondary grain growth, and the primary abnormal grain growth activating temperature is lower than the secondary abnormal grain growth activating temperature. When a uniform distribution of grain size breaks up due to the primary abnormal grain growth and the abnormal grains continuously grow to some extent in the polycrystalline body, the abnormal grains consume all of the original matrix grains and, thus, reach again another uniform distribution of grain size. The grain size under such a uniform distribution of grain size is even greater than the size of the matrix grains prior to the primary abnormal grain growth. When the polycrystalline body in which the primary abnormal grain growth has been completed is heat-treated again, a secondary abnormal grain growth can occur. As mentioned above, in comparison with the primary abnormal grain growth, when the secondary abnormal grain growth starts to occur, the size of matrix grains is remarkably higher that in the primary abnormal grain growth. Accordingly, the secondary abnormal grain growth makes it possible to control more carefully than the primary abnormal grain growth. As such, according to the invention, it is preferably to use the secondary abnormal grain growth rather than the primary abnormal grain growth.

The adjoining of the seed single crystal to the polycrystalline body and growing of the seed single crystal into the polycrystalline body include placing the seed single crystal on a powder-molded body or sintered body, embedding the seed single crystal in the powder, or adjoining the sintered body to the seed single crystal and then embedding the combination in the powder. Meanwhile, a single crystal having the same crystallographic structure as that of the polycrystalline body can be used as the seed single crystal.

When a polycrystalline thin film on the surface of the seed single crystal is grown and the average size of the matrix grains in the thin film is controlled during or after the thin film growth, the seed single crystal is continuously grown into the thin film during heat-treatment. Accordingly, it is possible to produce a new thin film single crystal on the seed single crystal. If the polycrystalline thin film on the seed single crystal is dense, it is possible to produce a perfectly dense single crystal thin film regardless of the density of the seed single crystal. If the composition of the polycrystalline thin film is different from that of the seed single crystal, it is possible to produce a new single crystal thin film having a composition different from that of the seed single crystal.

Meanwhile, when it is required to produce a single crystal having a desired crystal orientation, it is possible to change a crystal orientation of a single crystal to be grown into the polycrystalline body from the seed single crystal by predetermining a crystal orientation of the seed single crystal prior to adjoining the seed single crystal to the polycrystalline body, grinding a specific crystal face of the seed single crystal in the crystal orientation determined, and adjoining the ground seed single crystal to the polycrystalline body. In addition, when it is required to produce a single crystal comprising specific defects, it is possible to produce a single crystal comprising the same defects as those of the seed single crystal by using the seed single crystal comprising defects such as a single twin boundary, a double twin boundary, and a low angle grain boundary, etc..

For the purpose of inducing the abnormal grain growth only at the interface between the polycrystalline body and the seed single crystal and repressing it inside the polycrystalline body, the heat treatment can be carried out under the condition that additives for promoting abnormal grain growth are locally added at the interface between the seed single crystal and the polycrystalline body. The additives for promoting abnormal grain growth lower the abnormal grain growth activating temperature, and are preferably one or more selected from the group consisting of additives lowering the liquid phase generating temperature in the polycrystalline body.

Meanwhile, it is possible to produce a single crystal having a desired complex shape without a separate step of processing of the single crystal by using the powder that was molded or processed to a desired shape or a complex shape as the polycrystal. In addition, it is possible to control the porosity, the pore size and the pore shape inside the single crystal to be grown in the polycrystalline body and to produce perfectly dense single crystals destitute of pores and single crystals having various porosities, by adjoining a polycrystalline body having a different porosity, pore size and pore shape which was produced by adding an additive to the polycrystalline body or changing the amount of a liquid phase, sintering temperature, sintering atmosphere (oxygen partial pressure, degree of vacuum, etc.) and sintering pressure to the seed single crystal, and heat-treating the combination of the polycrystalline body and the seed single crystal. Also, it is possible to produce a single crystal having a structure which the pores are therein but not in the surface of thereof, by placing the seed single crystal on the polycrystalline body comprising the pores, heat-treating the combination, and growing the single crystal, thereby forming a perfectly dense layer on a surface of the single crystal. Additionally, as the polycrystalline body, it is possible to use a solid solution to which are added one or more selected from the group consisting of additives forming a solid solution with a crystallographic structure of the polycrystalline body.

In addition, in order to obtain a single crystal having a composition gradient, it is possible to produce a single crystal having a composition gradient that changes discontinuously or continuously, by making use of a polycrystalline body to which are added one or more selected from the group consisting of solutes to be solved into the crystallographic structure of the polycrystalline body composition.

The polycrystalline bodies comprise, for example, barium titanate (BaTiO₃), barium titanate solid solution ((BaₓM₁₋ₓ)(Ti_{y}N₁₋y)O₃) (0≤x≤1; 0≤y≤1), Pb(ZrₓTi₁₋ₓ)O₃ (0≤x≤1) (PZT) or PZT solid solution ((Pbₓ,M₁₋ₓ)(ZrₐTi_{b}N_{c})O₃ (0≤x≤1; 0≤a, b, c ≤1; a+b+c=1)), and other perovskite-type compositions (PbTiO₃ [PT], (1-*x*)Pb(Mg_{1/3}Nb_{2/3})O₃-xPbTiO₃ [(1-*x*)PMN-*x*PT], (1-*x*-*y*)Pb(Mg_{1/3}Nb_{2/3})O₃-*x*PbTiO₃-*y*PbZrO₃ [(1-*x-y*)PMN-*x*PT-*y*PZ], (1-x-*y*)Pb(Y-b_{1/2}Nb_{1/2})O₃-*x*PbTiO₃-*y*PbZrO₃ [(1-*x-y*)PYbN-*x*PT-*y*PZ], (1-x-*y*)Pb(In_{1/2}Nb_{1/2})O₃-*x*PbTiO₃-*y*PbZrO₃ [(1-*x-y*)PIN-*x*PT-*y*PZ], (1-*x-y*)PYbN-*x*PMN-*y*PT and (1-*x-y*)PIN-*x*PNM-*y*PT) (0≤x≤1; 0≤y≤1; 0≤x+y≤1) and perovskite-type solid solution thereof.

Hereinafter, a method for producing single crystals using nucleation control of abnormal grains according to the present invention will be described in more details with reference to the accompanying drawings.

A number density of abnormal grains is inversely proportional to an average size (R) of matrix grains of polycrystalline body, and in particular, becomes to "zero" beyond a critical size, at which the abnormal grain growth is totally repressed. Based on this phenomenon, a method for growing single crystals by controlling a number density of abnormal grains according to the invention includes (i) controlling a size of matrix grain in the polycrystalline body materials, which show abnormal grain growth, and repressing a number density of abnormal grains to the minimum, thereby allowing only one abnormal grain to be generated in the entire polycrystalline body, (ii) adjoining a seed single crystal having the same crystallographic structure as that of the polycrystalline body to the polycrystalline body and then heat-treating the combination of the seed single crystal and the polycrystalline body. Through the above (i), the only one generated abnormal grain can continue to be grown. Further, in case of (ii), the seed single crystal serves as an external nuclei of abnormal grain, thereby allowing the seed single crystal to be grown at the interface between the seed single crystal and the polycrystalline body, in order to allow the same structure as the seed single crystal to continue to be grown into the polycrystalline body. The single crystal obtained by the method has the same chemical composition as that of the original polycrystalline body with the seed single crystal adjoined thereto, and the same crystallographic structure as that of the seed single crystal. Accordingly, in the method according to the invention, the single crystal obtained by using the seed single crystal is the single crystal that has the chemical composition of the polycrystalline body and the crystallographic structure of the seed single crystal. Such a single crystal is herein referred to as "a single crystal having composition of the polycrystalline body".

The single crystals having various compositions produced according to this invention can be used as a seed single crystal in another method. In other words, another single crystal having composition of a polycrystalline body can be produced by adjoining a single crystal produced according to this invention to a polycrystalline body, and then allowing the same structure as the seed single crystal to continue to be grown in the polycrystalline body. Accordingly, this recycling of single crystals can reduce the cost for the seed single crystals.

Figs. 1a and 1b are schematic views that show a correlation between an average size (R) of matrix grains and a number density (ND, number of abnormal grains/unit area) of abnormal grains, and an average size (R) of matrix grains and a growth rate of a single crystal (a), and a continuous growth condition (0.5R_{c}≤R≤2R_{c}) of a seed single crystal (b), in the polycrystalline body which shows abnormal grain growth in the invention (R: average size of matrix grains, R_{c} : critical size of matrix grains at which nucleation of abnormal grains can be induced).

As can be seen from Fig. 1a, the number density (ND) of abnormal grains is inversely proportional to the average size (R) of matrix grains of polycrystalline body, and in particular, becomes to "zero" beyond a critical average size (R_{c}) of matrix grains for abnormal grain growth, so that the abnormal grain growth is totally repressed. Accordingly, the number density of abnormal grains can be controlled by controlling the average size of matrix grains of the polycrystalline body. Since the average size of matrix grains is inversely proportional to a driving force for abnormal grain growth, when the average size of matrix grains is small, abnormal grains can be rapidly grown in the early growth due to the higher driving force. However, since the number density of abnormal grains is high, abnormal grains collide with other surrounding abnormal grains. As a result, the grains cannot continuously grow, and finally cease to grow. When the average size of matrix grains increases, the number density of abnormal grains decreases and thus the driving force for abnormal grain growth also continuously decreases. When the average size of matrix grains is larger than the critical average size (R_{c}), abnormal grains can continue to grow without colliding with other abnormal grains. However, since the driving force for abnormal grain growth continuously decreases as the average size of matrix grains increases, the growth rate of abnormal grains decreases. As a result, the growth rate of abnormal grain according to the average size of matrix grains shows a maximum value adjacent to the critical average size (R_{c}). If the average size of matrix grains increases or decreases compared to R_{c}, the growth rate of abnormal grain in consequence decreases. Accordingly, it can be seen from Fig. 1a that when the average size of matrix grains of the polycrystalline body is approximately the critical average size (R_{c}), a newly generated abnormal grain or a seed single crystal can continue to be grown and a big single crystal can be produced.

Fig. 1b shows a continuous growth condition (0.5R_{c}≤R≤2R_{c}) for the seed single crystal, which a single crystal can be grown to more than several cm in the polycrystalline body. When the average size (R) of matrix grains of the polycrystalline body is smaller than the critical average size (R < R_{c}), as the average size decreases, the number density of abnormal grains increases and the generated abnormal grains collide with the growing single crystal, thereby obstructing the single crystal growth. As a result, when the size of matrix grain is too small (for example, R_{c} >> R =R₁), the single crystals cannot be grown. When the average size (R) of matrix grains is larger than R_{c} (R_{c}<R) the number density of abnormal grains is always "zero". However, if the size of matrix grains increases, the driving force for grain growth abruptly decreases. When the size of matrix grains is much larger than the critical average size (R_{c}) (R=R₂>>Rc), the driving force for grain growth becomes too small. Accordingly, even if the abnormal grain growth does not occur in the polycrystalline body, single crystals big enough for practical use cannot be produced because the growth rate of single crystal is too slow in the polycrystalline body. Thus, only when the average size of matrix grains of the polycrystalline body is within a specific range similar to the critical average size (R_{c}) of matrix grains, which can cause the abnormal grain growth to be induced, single crystals big enough for practical use can be produced.

As suggested in the embodiment of the invention, in general, when the average size of matrix grains of the polycrystalline body is smaller than 0.5R_{c} (R < 0.5R_{c}), the number density of abnormal grains is too large, so that the single crystals cannot be grown. When the average size of matrix grains of the polycrystalline body is larger than 2R_{c} (R > 2R_{c}), the number density of abnormal grains is zero. However, the growth rate of single crystals is too slow, so that big single crystals cannot be produced. Accordingly, by controlling the average size of matrix grains of the polycrystalline body to be within a specific range (0.5R_{c} ≤ R ≤ 2R_{c}), it is possible to control the number density of abnormal grains, to continue to grow the seed single crystal into the polycrystalline body through the same growth mechanism as the abnormal grain growth of the polycrystalline body, and thus to produce single crystals big enough for practical uses such as more than several cm. It is shown in Fig. 2a that the number density of abnormal grains and a degree of the abnormal grain growth vary as the average size of matrix grains varies in the polycrystalline body. It is shown in Fig. 2b that the number density of abnormal grains and a degree of the seed single grain growth vary as the average size of matrix grains varies in the polycrystalline body. In Fig. 2a, a condition (0.5R_{c} ≤ R ≤ R_{c}) of generating and growing only a limited number of abnormal grains is shown. In Fig. 2b, a condition (0.5R_{c}≤ R≤ 2R_{c}) of continuously growing the seed single crystal is shown. The condition of generating and growing only a limited number of abnormal grains is 0.5R_{c} ≤ R ≤ R_{c}. If R is smaller than 0.5R_{c}, it is impossible to grow only a limited number of abnormal grains because the number density of abnormal grains to be generated is too large. In addition, if R is larger than R_{c}, no abnormal grains can be generated.

By controlling the average size of matrix grains to be within a specific range in which the abnormal grain growth is repressed but the driving force for grain growth is sufficiently large, that is, by increasing the size of matrix grains to be included in the specific range when the size of matrix grains of the polycrystalline body is much smaller than R_{c} or by decreasing the size of matrix grains to be included in the specific range when the size of matrix grains of the polycrystalline body is much larger than R_{c}, thereby making the number of abnormal grains be minimum in the polycrystalline body, it is possible to continue to grow only the generated abnormal grains or to continue to grow the seed single crystal with the same growth mechanism as the abnormal grain growth of the polycrystalline body by sufficiently repressing the abnormal grain growth and adjoining the seed single crystal to the exterior of the polycrystalline body, thereby serving the seed single crystal as an external nucleus of abnormal grain. As a result of that, it is possible to produce a single crystal having composition of the polycrystalline body.

The adjoining of the seed single crystal to the polycrystalline body includes placing the seed single crystal on the powder-molded body or the polycrystalline body, embedding the seed single crystal in the powder, or embedding the combination of the seed single crystal and the polycrystalline body in the powder.

A polycrystalline thin film is grown by using a method of producing a polycrystalline thin film, and then the average size of matrix grains in the polycrystalline thin film during or after the thin film growth is controlled. A new thin film single crystal is produced by continuously growing a seed single crystal into the polycrystalline thin film during heat treatment.

In addition, the invention is **characterized in that** the single crystal growth is promoted by using a seed single crystal having a shape such as a simple plate-type or a rod-type, or a seed single crystal having a complex shape capable of making the growth rate of the seed single crystal be a maximum, such as "L" shape of a large crystal plane having a high growth rate.

A matrix grain growth always occurs during the heat treatment of the polycrystalline materials. The matrix grain growth is highly effected by chemical composition of the matrix grain, heat treatment temperature, type and amount of additives, type and amount of impurity, heat treatment atmosphere (particularly, oxygen partial pressure, degree of vacuum), density of polycrystalline body, pressure in pressure-sintering, etc. In the method according to this invention, the heat treatment is carried out such that the abnormal grain growth is repressed inside the polycrystalline body but is induced at the interface between the seed single crystal and the polycrystalline body to grow the same structure as the single crystal into the polycrystalline body by controlling the number density of abnormal grains in the polycrystalline body through a method of controlling the size of matrix grains of the polycrystalline body comprising controlling the composition of the polycrystalline body powder, the heat treatment temperature, the addition of additives, the heat treatment atmosphere, the density of polycrystalline body, and the pressure in pressure-sintering, etc. In particular, the average size of matrix grains and the number density of abnormal grains in the polycrystalline body are controlled by controlling the component ratio of the polycrystalline body, the heat treatment temperature, the heat treatment atmosphere, the density of polycrystalline body, and pressure in pressure-sintering, or by adding excess specific components of the polycrystalline body and additives having component different from that of matrix grain of the polycrystalline body. The average size of matrix grains in the polycrystalline body is controlled such a manner that when the size of matrix grains of the polycrystalline body is much smaller than R_{c}, the size of matrix grains is increased to be included in the specific range (0.5R_{c} ≤ R ≤ 2R_{c} in Fig.1b) or when the size of matrix grains of the polycrystalline body is much larger than R_{c}, the size of matrix grains is decreased to be included in the specific range (0.5R_{c} ≤ R ≤ 2R_{c} in Fig. 1b). Under the above conditions, the abnormal grain growth is repressed inside the polycrystalline body but is induced at the interface between the seed single crystal and the polycrystalline body to allow the seed single crystal to continue to be grown into the polycrystalline body through a heat treatment.

Further, the abnormal grain growth actively occurs as the heat treatment temperature increases in the polycrystalline body having the same chemical composition and the same average size condition of matrix grains. Based on this phenomenon, the seed single crystal growth is induced by continuing to heat the combination of the seed single crystal and the polycrystalline body under the temperature condition that the temperature of the interface between the seed single crystal and the polycrystalline body is controlled to be higher than the temperature of the polycrystalline body inside, and thus inducing the growth at the interface between the seed single crystal and the polycrystalline body and repressing it inside the polycrystalline body.

Further, after the abnormal grain growth is repressed inside the polycrystalline body by increasing the size of matrix grain beyond a specific critical size (R_{c} in Fig. 1b), if additives for promoting an abnormal grain growth are added to the interface between the seed single crystal and the polycrystalline body, and the combination is subject to heat-treating, the seed single crystal is allowed to rapidly be grown only at the interface between the seed single crystal and the polycrystalline body with an abnormal grain growth mechanism, so as to continue to grow the seed single crystal into the polycrystalline body, thereby producing a single crystal having a size big enough for a practice use.

The method for single crystal growth according to this invention is **characterized in that** a single crystal having a big size of more than several cm is produced by controlling a number density of abnormal grains through the control of the size of matrix grains of the polycrystalline body, thereby growing only a limited number of abnormal grains spontaneously generated in the polycrystalline body, or adjoining a seed single crystal to a polycrystalline body, thereby growing only the seed single crystal with an abnormal grain growth mechanism. Further, the present method is **characterized in that** a single crystal having composition of the polycrystalline body is produced by adjoining again the single crystal prepared according to the present method as a seed single crystal to a polycrystalline body, and then heat-treating the combination of the seed single crystal and the polycrystalline body, thereby continuing to grow the same structure as the seed single crystal into the polycrystalline body. As a result, a single crystal having composition of the polycrystalline body is produced.

Further, a single crystal to be grown from a seed single crystal in the polycrystalline body has the same crystallographic orientation as that of the seed single crystal, and when the defects are included in the seed single crystal, the growing single crystal also comprises the same defects. Based on this phenomenon, the method for single crystal growth according to the invention comprises grinding a specific crystal face of the seed single crystal in the crystallographic orientation, and adjoining the ground seed single crystal to the polycrystalline body, or adjoining a seed single crystal having specific defects (for example, single twin, double twin, grain boundary, etc.) to the polycrystalline body in order to easily produce single crystals having a desired specific crystallographic orientation and specific defects.

Further, the method according to this invention comprises the steps of molding the polycrystalline body powder to a desired shape or processing the polycrystalline body into a complex shape, and then adjoining the shaped or processed polycrystalline body to the seed single crystal, to produce a single crystal having a desired complicated shape without a expensive and complex separate step for processing the single crystal, based on the theory that a single crystal completely grown from the seed single crystal into the polycrystalline body has the same shape as that of the polycrystalline body adjoined to the seed single crystal.

Further, the method according to this invention comprises producing the polycrystalline body having porosity, pore shape and distribution of pore by controlling the heating temperature, heat treatment atmosphere (e.g., an oxygen partial pressure, a degree of vacuum), an external pressure during heat treating (pressure sintering), the amount of liquid phase and additives, adjoining the polycrystalline body to a seed single crystal, and then growing a single crystal, thereby making it possible to produce a single crystal having various pore structures. In addition, when a single crystal is grown in the perfectly dense polycrystalline body, perfectly dense single crystals free from pores can be grown in large quantities at low costs. Further, single crystals of, for example, BaTiO₃ [BT], BT solid solution ((BaₓM₁₋ₓ)(TiyN_{1-y})O₃) (e.g., Ba(Ti,Zr)O₃ [BTZ], Ba(Ti,Sn)O₃ [BTS], (Ba,Sr)TiO₃ [BST]), Pb(ZrₓTi₁₋ₓ)O₃ [PZT], (Pb_{y},La_{1-y})(ZrₓTi₁₋ₓ)O₃ [PLZT], (100-*x*)Pb(Mg_{1/3}Nb_{2/3})O₃-(*x*)PbTiO₃ [(100-*x*)PMN-(*x*)PT], (100-*x*)PMN-(*x*)BT, (100-*x*-*y*)PMN-*x*PT-*y*BT, (100-*x*-*y*)PMN-*x*PT-yPZ, solid solutions thereof, and single crystals having various compositions can be produced in large quantities at low costs by using a big seed single crystal having a size of more than 40 x 40 mm prepared according to the invention.

Hereinafter, preferred embodiments of a method according to the present invention will be described in detail.

### <Example 1>

Ba(Ti,Zr)O₃ has excellent dielectric, piezoelectric and electro-optical properties and is used as a core material of the various kinds of electronic parts. In this Example, Ba(Ti,Zr)O₃ was used as the polycrystalline body, and Ba(Ti,Zr)O₃ having one or more components higher or lower than those of the original composition thereof was subject to heat treatment, thereby causing the average size of matrix grains and the number density of abnormal grains to be controlled. Ba(Ti,Zr)O₃ powders were prepared by mixing BaCO_{3,} TiO₂ and ZrO₂ powders and then calcining the mixture at 1200°C in the air. The powders having various compositions comprising excess TiO₂ were prepared by adding excess TiO₂ to the prepared Ba(Ti,Zr)O₃ powder in the amount of 0.1 mol% to 1.0 mol%. Then, the powders comprising added TiO₂ were molded in a quadrangle mold and the molded powders were subject to cold isostatic pressing at the pressure of 200 MPa. The powder-molded bodies were subject to heat-treating at the temperatures higher than 1300°C for up to 200 hours in the air. A Ba(Ti_{0.7}Zr_{0.3})O₃ seed single crystal was placed on the prepared polycrystalline body, and the combination was subject to heat-treating at 1380°C for up to 200 hours.

Fig. 3 is a graph showing the correlations between the average size (R) of matrix grains and the number density (ND) of the abnormal grains generated in the polycrystalline body, and between the average size (R) of matrix grains and a growth rate of a seed single crystal into the polycrystalline body, in a sample obtained by heat treating the powder molded bodies having the composition formula of Ba(Ti_{0.7}Zr_{0.3})O₃ [(100-*x*)Ba(Ti_{0.7}Zr_{0.3})O₃-*x*TiO₂; 0≤x≤1] composition, to which TiO₂ was added in the amount of 0.0% to 1.0%, at 1380°C for 15 hours in the air. When excess TiO₂ powder of 0.0 mol% to 1.0 mol% was added to Ba(Ti_{0.7}Zr_{0.3})O₃ powder and then the powders were sintered, the size of matrix grains continuously decreased as the amount of TiO₂ increased. When TiO₂ of 0.5 mol% or more was added, an abnormal grain growth occurred in the polycrystalline body. As the amount of TiO₂ increased, the size of matrix grains in the polycrystalline body decreased and the number density of abnormal grains continued to increase. In the sample to which TiO₂ of 0.5 mol% was added, the number density of abnormal grains decreased to 2 abnormal grains/cm², so that the size of abnormal grains reached a critical size (R_{c}) of matrix grains for abnormal grain growth (Rc ≅ 90 µm). In the sample of (99.8)Ba(Ti_{0.7}Zr_{0.3})O₃-(0.2)TiO₂, the size of matrix grains was so large that the abnormal grain growth did not occur in the polycrystalline body. In the sample of (99.8)Ba(Ti_{0.7}Zr_{0.3})O₃-(0.8)TiO_{2,} the size of matrix grains was much smaller than the critical size, so that the number density of abnormal grains was very high, and thus the abnormal grain growth actively occurred. In Fig. 3, the average sizes of matrix grains having the respective compositions is (a) 210 µm [(99.8)Ba(Ti_{0.7}Zr_{0.3})O₃-(0.2)TiO₂], (b) 90 µm [(99.8)Ba(Ti_{0.7}Zr_{0.3})O₃-(0.5)TiO₂] and (c) 35 µm [(99.8)Ba(Ti_{0.7}Zr_{0.3})O₃-(0.8)TiO₂], respectively, the critical size (R_{c}) of matrix grains for abnormal grain growth was about 90 µm. In the sample of [(99.8)Ba(Ti_{0.7}Zr_{0.3})O₃-(0.2)TiO₂] in which the average size of matrix grains is twice (i.e. 180 µm or more) the critical size, the abnormal grain growth did not occur. However, the driving force for grain growth was so small that the growth rate of the seed single crystal was 30 µm/h or less. In the case that the growth rate of the seed single crystal was 30 µm /h or less, single crystals large enough for practical use could not be produced even though the heat treatment was carried out for long hours. Accordingly, this case was not suitable for producing the single crystals. In the sample of [(99.8)Ba(Ti_{0.7}Zr_{0.3})O₃-(0.8)TiO₂] in which the average size of matrix grains was half (i.e., 45 µm or less) the critical size, the driving force was high in the early of the heat treatment, so that the seed single crystal growth rapidly occurred. However, since many abnormal grains were generated around the growing seed single crystal, they collided with the growing seed single crystal, thereby obstructing the seed single crystal growth. Like this, in the case that the number density of abnormal grains was high, single crystals large enough for practical use could not be produced due to the collision with the abnormal grains. Accordingly, this case was not suitable for producing the single crystals. As a result, when the relation between the average size of matrix grains and the single crystal growth was examined, it was possible to grow the seed single crystal to 1 cm or more only if the size of matrix grains was 45 µm or more, or 180 µm or less. Accordingly, the range of the average size (R) of matrix grains, in which the seed single crystal can continue to be grown, can be associated with the critical size (R_{c} in Fig. 1) of matrix grains for abnormal grain growth as follows; 0.5R_{c} ≤ R ≤ 2R_{c}.

Fig. 4 is a photograph showing a single crystal grown from a sample obtained by placing a seed single crystal having the composition formula of Ba(Ti_{0.7}Zr_{0.3})O₃ on a polycrystalline body having the composition formula of (99.6)Ba(Ti_{0.7}Zr_{0.3})O₃-(0.4)TiO₂, and then heat-treating the combination at 1380°C for 200 hours. In the sample [(99.6)Ba(Ti_{0.7}Zr_{0.3})O₃-(0.4)TiO₂] of Fig. 4 to which TiO₂ was added in the contents lower than the sample [(99.5)Ba(Ti_{0.7}Zr_{0.3})O₃-(0.5)TiO₂] of Fig. 3 in which the size of matrix grains was similar to the critical size of matrix grains for abnormal grain growth by 0.1 mol%, since the size of matrix grains was slightly larger than the critical size (R_{c} in Fig. 1) of abnormal grains, the abnormal grain growth did not occur inside the polycrystalline body. Since the seed single crystal continued to grow into the polycrystalline body without colliding with the abnormal grains during the heat treatment, a large seed single crystal having a size of 20 x 20 mm or more was produced.

When the average size of matrix grains of the polycrystalline body was continuously decreased by adding excess TiO₂ powder to Ba(Ti_{0.7}Zr_{0.3})O₃ powder, it was possible to control the average size of matrix grains of the polycrystalline body to be slightly larger than the critical size (R_{c} in Fig. 1) for abnormal grain growth in case of adding a specific amount of TiO₂ (Fig. 4). In this case, the abnormal grain growth did not occur inside the polycrystalline body, and the seed single crystal continued to be grown into the polycrystalline body with a mechanism such as an abnormal grain growth by serving as an external nucleus for abnormal grain growth, so that a big single crystal was produced in the polycrystalline body. The size of the produced single crystal was proportional to the heat treatment time. The range of the average size (R) of matrix grains, in which the seed single crystal can be grown, was 0.5R_{c} ≤ R ≤ 2R_{c} (R_{c}: critical size of matrix grains for abnormal grain growth).

### <Example 2>

The average size of matrix grains of polycrystalline body is changed depending on the heat treatment atmosphere (e.g., air, oxygen, hydrogen, oxygen partial pressure, degree of vacuum). Based on this theory, in this example, the average size of matrix grains of the polycrystalline body was controlled by primarily heat-treating only the polycrystalline body in the atmosphere different from the atmosphere for a single crystal growth prior to the secondary heat treatment for the single crystal growth. When the average size of matrix grains of the polycrystalline body prepared in the primary heat treatment is controlled to be within the range of 0.5R_{c} ≤ R ≤ 2R_{c} under the condition of a secondary heat treatment, it is possible to continuously grow only the seed single crystal or a limited number of abnormal grains generated in the primary heat treatment during the secondary heat treatment. The production and the atmosphere of powder used in this example were same as those of the Example 1. The powder-molded bodies were subject to heat-treating at the temperatures higher than 1300°C for up to 200 hours while changing the oxygen partial pressure (Pₒ₂) of the heat treatment atmosphere.

When a polycrystalline body sample having the composition formula of (99.2)Ba(Ti_{0.7}Zr_{0.3})O₃-(0.8)TiO₂ was sintered at 1380°C in the air atmosphere of oxygen partial pressure of 0.2, the average size of matrix grains was about 30 µm and the abnormal grain growth actively occurred. When the sample was sintered at 1380°C in the atmosphere of oxygen partial pressure of 0.01 or less, the average size of matrix grains was about 110 µm and the abnormal grain growth did not occur. As the oxygen partial pressure decreased, the size of matrix grains of barium titanate-type polycrystalline body continued to increase. Under some heat treatment temperatures, the average size of matrix grains of polycrystalline body became larger than the critical size of matrix grains for abnormal grain growth at a specific oxygen partial pressure or less, so that an abnormal grain growth did not occur.

Fig. 5 is a photograph showing a sample obtained by sintering a polycrystalline body sample having the composition formula of (99.2)Ba(Ti_{0.7}Zr_{0.3})O₃-(0.8)TiO₂ at 1380°C for 5 hours in the reductive atmosphere of oxygen partial pressure of 0.01 or less, placing a seed single crystal of Ba(Ti_{0.7}Zr_{0.3})O₃ on the sintered polycrystalline body sample, and heat-treating the combination at 1380°C for 200 hours in the air atmosphere. When the sample having the composition formula of (99.2)Ba(Ti_{0.7}Zr_{0.3})O₃-(0.8)TiO₂ was sintered in the air, the seed single crystal was adjoined to the sintered sample, and then the combination of the seed single crystal and the sample was heat-treated, the seed single crystal could not be grown since the size of matrix grains was too small (i.e., R < 0.5R_{c}), and thus the number density of abnormal grains was too high. When the seed single crystal was adjoined to the (99.2)Ba(Ti_{0.7}Zr_{0.3})O₃-(0.8)TiO₂ sample, and then the combination was subject to the heat treatment only in the reductive atmosphere of oxygen partial pressure of 0.01 or less, the seed single crystal could not be grown because the matrix grains continued to grow to such a size larger than 2R_{c}, and thus the driving force for single crystal growth became too small. However, the example in Fig. 5 controlled the average size (R) of matrix grains of the polycrystalline body to be within the range of 0.5R_{c} ≤ R≤ 2R_{c} under the condition of the secondary heat treatment by promoting a grain growth of the polycrystalline body in the atmosphere of low oxygen partial pressure. After that, the seed single crystal and the polycrystalline body were adjoined together, and the combination was subject to the heat treatment for the purpose of growing single crystals in the air of high oxygen partial pressure in which the growth of matrix grains is repressed in the polycrystalline body, so that an abnormal grain growth was repressed in the polycrystalline body and the driving force for seed single crystal growth was maintained to be high. As a result, the seed single crystal continued to be grown into the polycrystalline body as shown in Fig. 5. The seed single crystal growth was proportional to the heat treatment time, and Ba(Ti_{0.7}Zr_{0.3})O₃ single crystal having 25 x 25 mm or more was produced in the polycrystalline body through a heat treatment for long hours (Fig. 5).

As shown in Fig. 5, in the method for increasing the size of matrix grains in order to repress the abnormal grain growth in the polycrystalline body, based on the theory that the average size of matrix grains is changed depending on the heat treatment atmosphere, the polycrystalline body was subject to the primary heat treatment in the atmosphere promoting the grain growth to increase the size of the matrix grains, and then the heat treatment for the seed single crystal growth was carried out in the heat treatment atmosphere capable of continuing to grow the seed single crystal into the polycrystalline body. As a result, it was possible to produce a big single crystal having a size of several tens mm while effectively repressing the abnormal grain growth in the polycrystalline body.

### <Example 3>

The abnormal grain growth in the polycrystalline body can always occur if the average size of matrix grains is smaller than the critical size of matrix grains for abnormal grain growth. When the abnormal grain growth occurs, abnormal grains grow while consuming the matrix grains. When the abnormal grains have completely consumed all the matrix grains, the abnormal grain growth is completed. After the completion of the abnormal grain growth, the abnormal grain growth can again occur if the size of the abnormal grains is not so sufficiently large that the size is smaller than the critical size (R_{c} in Fig. 1) of matrix grains for abnormal grain growth. In this case, the early-generated abnormal grain growth is referred to as a primary abnormal grain growth, and the later generated abnormal grain growth is referred to as a secondary abnormal grain growth. Like this, the abnormal grain growth can repeatedly occur, and when the abnormal grain growth occurs and then has been completed, the average size of matrix grains rapidly increases. Accordingly, the average size of matrix grains can be controlled by repeatedly inducing the abnormal grain growth. The production and heat treatment of the powder used in this Example were same as those of the Example 1.

When (99.8)Ba(Ti_{0.95}Zr_{0.05})O₃-(0.2)TiO₂ powder-molded body were heat-treated (a) at 1300°C (1h) and (b) at 1365°C (50h) in the air, respectively, the abnormal grain growth progressed at 1300°C and the size of matrix grains was about 3 µm. The size of abnormal grains was about 30 µm, and the number density of abnormal grains was about 50,000 abnormal grains/cm². The temperature at which the primary abnormal grain growth starts to occur is changed depending on the ratio of barium/titanium or the contents of additives in the powder. The primary abnormal grain growth starting temperature of (99.8)Ba(Ti_{0.95}Zr_{0.05})O₃-(0.2)TiO₂ powder used in this Example was about 1300°C. When the heat treatment time was increased, the abnormal grains were grown while consuming the matrix grains and have completely consumed all the matrix grains, so that the primary abnormal grain growth was completed. As a result, a microstructure of the sample consisting of only the primary abnormal grains was obtained. The average size of matrix grains of the polycrystalline body (1300°C) in which the primary abnormal grain growth occurred was about 3 µm, and the average size of matrix grains after the completion of the primary abnormal grain growth was about 35 µm. That is, the average size of matrix grains after the completion of the primary abnormal grain growth was rapidly increased to 12 times size. At 1365°C, the primary abnormal grain growth has been completed, and thus a microstructure of the sample in which the abnormal grain growth again occurred as the temperature increased in the sample consisting of only the primary abnormal grains, i.e., a microstructure of the sample in which the secondary abnormal grain growth occurred was obtained. The temperature at which the secondary abnormal grain growth starts to occur is changed depending on the ratio of barium/titanium or the contents of additives in the powder. The secondary abnormal grain growth starting temperature of the barium titanate powder used in this Example was about 1365°C. When the powder was sintered at 1365°C for 50 hours, the secondary abnormal grain growth progressed, and the size of matrix grains was about 90 µm. The size of secondary abnormal grains was about 1500 µm, and the number density of abnormal grains was about 2 (two) abnormal grains/cm².

Fig. 6 is a photograph showing a secondary abnormal grain (i.e., a single crystal of Ba(Ti_{0.95}Zr_{0.05})O₃) spontaneously grown on a big scale in the sample obtained by heat-treating powder-molded body having the composition formula of (99.9)Ba(Ti_{0.95}Zr_{0.05})O₃-(0.2)TiO₂ at 1370°C for 200 hours in the air. When the primary abnormal grain growth was induced in polycrystalline body, the size of matrix grains of the polycrystalline body was rapidly increased from 3 µm to 35 µm. When the secondary abnormal grain growth occurred again in the polycrystalline body in which the primary abnormal grain growth had been completed, the average size of matrix grains was about 90 µm slightly smaller than the critical size (R_{c} in Fig. 1) of matrix grains for secondary abnormal grain growth. Accordingly, when the polycrystalline body in which the primary abnormal grain growth had been completed was heat-treated again at 1370°C, the number density of the secondary abnormal grains was about 2 abnormal grains/cm², and the secondary abnormal grains continued to be grown without colliding with other secondary abnormal grains, thereby a single crystal having a size of 1 cm or more being obtained. When the number density of abnormal grains was about 2 abnormal grains/cm² or less, it was possible to produce single crystals having the size of more than several cm without an external seed single crystal.

When an abnormal grain growth occurs and has been completed in polycrystalline body, the average size of matrix grains is rapidly increased. Accordingly, the size of matrix grains can be controlled by repeatedly inducing the abnormal grain growth. Based on this theory, as shown in Fig. 6, in the method for increasing the size of matrix grains in order to repress the abnormal grain growth in the polycrystalline body, it was possible to produce a big single crystal having a size of several cm while repressing the abnormal grain growth in the polycrystalline body, by primarily heat-treating the polycrystalline body, which heat treatment induced the abnormal grain growth and has completed it in the polycrystalline body, to increase the size of matrix grains, adjoining a seed single crystal to the polycrystalline body in which the abnormal grain growth had been completed, and then heat-treating the combination for the seed single crystal growth.

### <Example 4>

In this Example, the average size of matrix grains of the polycrystalline body was controlled by primarily heat-treating only the polycrystalline body at the temperature higher than the temperature for single crystal growth prior to the secondary heat treatment for single crystal growth, based on a theory that the average size of matrix grains of polycrystalline body is increased proportionally to heat treatment temperature. The secondary heat treatment for single crystal growth was carried out at the temperature lower than the primary sintering temperature. At the secondary heat treatment temperature, the size of matrix grains and the number density of abnormal grains in the polycrystalline body were controlled by repressing the abnormal grain growth in the polycrystalline body. Under some heat treatments carried out only at the heat treatment temperature for single crystal growth, it was difficult to make the average size of matrix grains of the polycrystalline body be larger than the critical size (R_{c} in Fig. 1) of matrix grains for abnormal grain growth. In this case, a single crystal could be grown by primarily heat-treating the polycrystalline body at the temperature higher than the secondary heat treatment temperature for single crystal growth, and thus controlling the average size of matrix grains of the polycrystalline body to be within the range of 0.5R_{c} ≤ R ≤ 2R_{c} at the heat treatment temperature (i.e., the secondary heat treatment temperature) for single crystal growth. The production and the atmosphere of powder used in this Example were same as those of the Example 1.

When the sintered bodies having the composition formula of (99.8)Ba(Ti_{0.95}Zr_{0.05})O₃-(0.2)TiO₂ was subject to heat treatment at 1360°C or less, it was impossible to continue to grow the seed single crystal because the abnormal grain growth actively occurred and thus the number density of abnormal grains was too large. When the powder-molded body having the composition formula of (99.8)Ba(Ti_{0.95}Zr_{0.05})O₃-(0.2)TiO₂ was subject to sintering at 1390°C for long hours in the air, the abnormal grain growth did not occur because the matrix grains normally continued to be grown and thus the size of matrix grains became larger than the critical size (R_{c} in Fig. 1) of matrix grains for abnormal grain growth. When the seed single crystal was adjoined to the polycrystalline body having the composition formula of (99.8)Ba(Ti_{0.95}Zr_{0.05})O₃-(0.2)TiO₂ and then the combination was continuously subject to heat-treating, it was impossible to grow the seed single crystal because the size of matrix grains became larger than 2R_{c} beyond the continuous growth condition of the seed single crystal (i.e., 0.5R_{c} ≤ R ≤ 2R_{c}).

FIG. 7 is a photograph showing a sample obtained by primarily heat-treating the powder-molded body having the composition formula of (99.8)Ba(Ti_{0.95}Zr_{0.05})O₃-(0.2)TiO₂ at 1390°C for 5 hours, placing a single crystal of Ba(Ti_{0.95}Zr_{0.05})O₃ on the sintered bodies, and then heat-treating the combination at 1370°C for 200 hours in the air. When the molded bodies having the composition formula of (99.8)Ba(Ti_{0.95}Zr_{0.05})O₃-(0.2)TiO₂ was not subject to the primary heat treatment at 1390°C, the size of matrix grains of the sintered polycrystalline body was smaller than the continuous growth condition of the seed single crystal (i.e., R < 0.5R_{c}), and thus the size of single crystal to be grown was limited due to the abnormal grains generated in the polycrystalline body. However, when the bodies was subject to heat-treating at 1390°C for 5 hours prior to heat-treating for the single crystal growth at 1370°C in order to allow the size of matrix grains to be increased above the critical size (R_{c} in Fig. 1) of matrix grains for abnormal grain growth, the number density of abnormal grains became 0 (zero) grain/cm². In the sample (Fig. 7) obtained by placing a single crystal of Ba(Ti_{0.95}Zr_{0.05})O₃ on the sintered body which had been subject to the primary sintering at 1390°C for 5 hours, and then heat-treating the combination at 1370°C for 200 hours, the seed single crystal continued to be grown. In addition, since the abnormal grains were not generated in the polycrystalline body, single crystal growth was not limited, and thus the single crystal continued to be grown proportionally to the heat treatment time.

As shown in Fig. 7, in the method for increasing the size of matrix grains in order to repress the abnormal grain growth in the polycrystalline body, based on the theory that the average size of matrix grains increases as the heat treatment temperature rises, the seed single crystal could be grown while effectively repressing the abnormal grain growth in the polycrystalline body by primarily heat-treating the polycrystalline body at the high temperature to increase the size of the matrix grains to be included in the range 0.5R_{c} ≤ R ≤ 2R_{c}, and then heat-treating to grow the seed single crystal at the low temperature. In the Examples 3 and 4, the range of the average size of matrix grains, in which the seed single crystal can be grown, was 0.5R_{c} ≤ R ≤ 2R_{c} (Rc is the critical size of matrix grains for abnormal grain growth).

### <Example 5>

When the polycrystalline body to which the additives different from the components of the polycrystalline body was added is subject to the heat treatment, the size of matrix grains increases or decreases depending on the type and amount of the additives. Accordingly, when the abnormal grain growth is controlled by adding one or more suitable additives different from the components of the polycrystalline body to it, and thus controlling the size of matrix grains to be within the range of 0.5R_{c} ≤ R ≤ 2R_{c}, a single crystal can be produced by continuing to grow the abnormal grain or the seed single crystal into the polycrystalline body. In this Example, the abnormal grain growth was controlled by adding the additives different from the components of a polycrystalline body of barium titanate to the polycrystalline body, and then heat-treating the polycrystalline body, thereby controlling the size of matrix grains. The barium/titanium ratio was 0.998 in the barium titanate powder used in the experiment, and ZrO₂ was added to the barium titanate powder, thereby producing powders having various compositions. The powders comprising ZrO₂ were molded in a quadrangle mold and then the molded powders were subject to pressure molding at the isostatic pressure of 200 MPa. The powder-molded bodies were subject to the heat treatment at the temperatures higher than 1300°C for up to 200 hours in the air.

When BaTiO₃ powder to which ZrO₂ powder had been added in the contents of 0.1 mol% ∼ 1.0 mol% was subject to sintering at 1380°C, the size of matrix grains of the sintered body was continuously decreased as the content of ZrO₂ was increased. When ZrO₂ of more than 0.5 mol% was added, the abnormal grain growth occurred, and the number density of abnormal grains was continuously increased as the content of ZrO₂ was increased, i.e., the size of matrix grains was decreased. When ZrO₂ of about 0.5 mol% was added, the size of matrix grains reached the critical size (R_{c} in Fig. 1) of matrix grains for abnormal grain growth, and the abnormal grain growth started to occur. The relationship between the average size of matrix grains and the number density of abnormal grains in the respective samples is as follows: in the sample to which ZrO₂ was added in less quantities, the size of matrix grains was the biggest and the abnormal grains could not be observed, and in the sample to which ZrO₂ of more than 0.5 mol% was added, the abnormal grains was observed and the number density of abnormal grains was increased as the contents of ZrO₂ were increased. In this Example, the critical size (R_{c} in Fig. 1) of matrix grains for abnormal grain growth was about 100 µm in the polycrystalline body of barium titanate with ZrO₂ added thereto.

Fig. 8 is a photograph showing a single crystal grown from a sample obtained by placing a single crystal of barium titanate on the powder-molded body having the composition formula of (99.6)BaTiO₃-(0.4)ZrO₂, and then heat-treating the combination at 1380°C for 200 hours. In the sample having the composition formula of (99.6)BaTiO₃-(0.4)ZrO₂, the average size of matrix grains was included in the range of R_{c} < R ≤ 2R_{c}, and the abnormal grains were not generated in the polycrystalline body. Accordingly, the seed single crystal continued to be grown into the polycrystalline body, causing a big single crystal to be produced.

When ZrO₂ powder was added to the barium titanate powder to continuously decrease the average size of matrix grains of polycrystalline body, the average size of matrix grains of the polycrystalline body of barium titanate could be controlled to be included within the range of R_{c} < R ≤ 2R_{c} by adding a specific amount of ZrO₂ powder (Fig. 8). In this case, the abnormal grain growth did not occur inside the polycrystalline body, and the seed single crystal of barium titanate continued to be grown into the polycrystalline body with a mechanism such as a abnormal grain growth by serving as an external nucleus for abnormal grain growth, so that a big single crystal was produced in the polycrystalline body. The size of the produced single crystal was proportional to the heat treatment time. In this Example, the range of the average size of matrix grains, in which the seed single crystal could be grown, was 0.5R_{c} ≤ R ≤ 2R_{c} (Rc is the critical size of matrix grains for abnormal grain growth).

### <Example 6>

In this Example, the size of matrix grains and the number density of abnormal grains were controlled by adding excess one or more components of (68)Pb(Mg_{1/3}Nb_{2/3})O₃-(32)PbTiO₃ [(68)PMN-(32)PT in mol%]-type polycrystalline body oxide which has excellent piezoelectric and dielectric properties to the polycrystalline body, and then heat-treating the polycrystalline body. Firstly, (68)PMN-(32)PT powder was prepared by the Columbite precursor method. The preparing process of the powder was as follows: magnesium niobate (MgNb₂O₆) was prepared by ball-milling magnesium carbonate hydroxide (4MgCO₃·Mg(OH)₂·4H₂O) and niobium oxide (Nb₂O₅) powders in ethanol, and then calcining them at 1100°C for 4 hours. Finally, (68)PMN-(32)PT powder was prepared by mixing the calcined magnesium niobate (MgNb₂O₆) with lead oxide (PbO) and titanium dioxide (TiO₂) powders, ball-milling the mixture and then calcining it at 850°C for 4 hours. In mixing the powders, the powders having various compositions were prepared by controlling the ratio of lead oxide, niobium oxide, magnesium carbonate hydroxide, and titanium dioxide. Powder-molded bodies were prepared by uniaxial pressure molding. Then, the powder-molded bodies were subjected to CIP (cold isostatic pressing) at the pressure of 200 MPa. They were sintered on a platinum (Pt) plate in a double platinum crucible, and atmospheric powders such as lead zirconate (PbZrO₃ [PZ]) and PbO powder were placed around the sample to repress the volatilization of PbO during sintering.

An excess MgO was added to the powder having the composition formula of (68)Pb(Mg_{1/3}Nb_{2/3})O₃-(32)PbTiO₃ [(68)PMN-(32)PT], and the powder-molded body was sintered at 1200°C for 10 hours in the air. In the sample to which excess MgO had not been added, the abnormal grain growth could not be observed, and the size of matrix grains was no more than 8 µm. Based on the contents of MgO included in 68PMN-32PT composition, an excess MgO of 0% ∼ 15% was added in order to observe the size change of matrix grains depending on the excess MgO addition. As the additive amount of excess MgO was increased, the matrix grain growth actively occurred, and the size of matrix grains was continuously increased to 25 µm. As a result, the size of matrix grains was about three times the size of the matrix grains of the sample with no excess MgO added thereto.

In the polycrystalline body having the composition formula of (90)[68PMN-32PT]-(10)PbO with excess PbO added thereto, the changes of the size of matrix grains and the number density of abnormal grains were measured depending on the change of the amount of excess MgO. The average sizes of the samples to which 0% MgO (0MgO) and 4% MgO had been respectively added in excess was about 12 µm and 40 µm, respectively. As the additive amount of excess MgO was increased, the size of matrix grains was also continuously increased. In the sample having the composition formula of (90)[68PMN-32PT]-(10)PbO with excess PbO added thereto, when excess MgO was added in the amount of less than 2%, the abnormal grain growth was distinctly observed, but when excess MgO was added in the amount of 2% or more, the abnormal grain growth did not occur. That is, when excess MgO was added in the amount of less than 2%, the abnormal grain growth actively occurred in the polycrystalline body because the size of matrix grains became smaller than the critical average size (R_{c} in Fig. 1) of matrix grains for inducing abnormal grain growth. However, when excess MgO was added in the predetermined amount or more, the abnormal grain growth did not occur in the polycrystalline body because the size of matrix grains was increased beyond the critical average size (R_{c} in Fig. 1) of matrix grains for inducing abnormal grain growth. In this Example, the critical average size of matrix grains for inducing abnormal grain growth was about 28 µm. Accordingly, it was possible to produce a single crystal when the average size of matrix grains was 14 µm or more or 56 µm or less (0.5R_{c} ≤ R ≤ 2R_{c}).

Fig. 9 is a photograph showing a surface of a sample obtained by placing a seed single crystal of barium titanate on a powder-molded body comprising the powder having the composition formula of (90)[68PMN-32PT]-(10)PbO with 2% MgO (2MgO)-extra added thereto, and then heat-treating the combination at 1200°C for 100 hours. In the sample to which excess MgO was not added, PMN-PT single crystal was grown in the seed single crystal of barium titanate, but collided with the abnormal grains generated in the polycrystalline body, so that it was grown to only several mm and stopped to grow. However, in the sample shown in Fig. 9 to which excess MgO of 2% was added, (68)PMN-(32)PT single crystal continued to be grown in the seed single crystal of barium titanate because abnormal grains were not generated in the polycrystalline body. The size of the grown PMN-PT single crystal was proportional to the heat treatment time.

When the abnormal grain growth was induced by adding excess PbO to PMN-PT powder and the average size of matrix grains of the polycrystalline body was continuously increased by adding excess MgO, it was possible to control the average size of matrix grains of PMN-PT polycrystalline body to be slightly larger than the critical size (R_{c} in Fig. 1) of matrix grains for abnormal grain growth in case of adding excess MgO in a specific amount or more. In this case, the seed single crystal continued to grow into the PMN-PT polycrystalline body, thereby making it possible to produce a big PMN-PT single crystal inside the polycrystalline body. The range of the average size of matrix grains, in which the seed single crystal could be grown, was 0.5R_{c} ≤ R ≤ 2R_{c} (Rc is the critical size of matrix grains for abnormal grain growth).

### <Example 7>

In this Example, based on a method that the size of matrix grains is controlled by changing the component ratio of Pb(ZrₓTi₁₋ₓ)O₃ (PZT) which is most widely used as the piezoelectric material, the PZT single crystal was produced by controlling the abnormal grain growth in the polycrystalline body and then heat-treating the seed single crystal of Ba(Ti_{0.7}Zr_{0.3})O₃ to continue to be grown into the polycrystalline body. The PZT powder was prepared by ball-milling PbO, ZrO₂ and TiO₂ powders in ethanol, and then calcining them at 800°C for 4 hours. In addition, Pb(ZrₓTi₁₋ₓ)O₃ powders having different x values in the composition formula were prepared by controlling the ratio of ZrO₂ and TiO₂. Powder-molded bodies were prepared by uniaxial pressure molding. Then, the powder-molded body was subjected to CIP at the pressure of 200 MPa. They were sintered on a platinum (Pt) plate in a double platinum crucible, and atmospheric powders such as lead zirconate (PbZrO₃ [PZ]) and PbO powder were placed around the sample to repress the volatilization of PbO during sintering.

When the various Pb(Zr,Ti)O₃ sintered bodies having different Zr/Ti ratios in the composition formula were sintered at 1200°C for one hour, there was a tendency that the size of matrix grains of polycrystalline body increased as the Zr/Ti ratio increased. In the samples having Zr/Ti = 0.72, 1.08 and 1.21, respectively, the sizes of matrix grains were 2 µm, 6 µm and 10 µm, respectively. That is, the average size of matrix grains continued to increase as Zr/Ti ratio increased. In addition, the microstructure was observed after adding excess PbO to the various Pb(Zr,Ti)O₃ powders having different Zr/Ti ratios in the composition formula, preparing powder-molded bodies with PbO having various compositions added thereto, and then sintering them at 1200°C for one hour.

When excess PbO of 10 mol% was added to Pb(ZrₓTi₁₋ₓ)O₃ (PZT) powders which had been prepared while changing Zr/Ti ratios within a range of 4∼0.25, respectively, and then the combination was sintered, the size of matrix grains of the sintered bodies continued to increase as the Zr/Ti ratio increased. The sample having Zr/Ti ratio (= 0.72) showed a microstructure that the abnormal grain growth occurred in the matrix grains having the size of 3 µm, the matrix grains were thus completely consumed, and only the abnormal grains remained. In the samples having Zr/Ti = 1.08 and 1.21, the average sizes of matrix grains were 12 µm and 15 µm, respectively. When the Zr/Ti ratio was about 0.85 or less, the size of matrix grains reached the critical size (R_{c} in Fig. 1) of matrix grains for abnormal grain growth, the critical size was about 10 µm and the abnormal grain growth started to occur. When excess PbO was added to the polycrystalline sample and liquid phase was supplied to it, the abnormal grain growth occurred in the matrix grains having sufficiently large sizes (e.g., the samples having Zr/Ti (= 1.08 and 1.21)), but did not occur in the matrix grains having sufficiently small sizes (e.g., the sample having Zr/Ti (= 0.72)).

Fig. 10 is a photograph showing a PZT single crystal grown from a sample obtained by embedding a single crystal of Ba(Ti_{0.7}Zr_{0.3})O₃ in a powder-molded body having the composition formula of (90)[Pb(Zr_{0.46}Ti_{0.54})O₃]-(10)PbO, and then heat-treating the combination at 1200°C for 100 hours. When the Zr/Ti ratio was controlled to be 0.85, the size of matrix grains was about 10 µm that was the critical size (R_{c} in Fig. 1) of matrix grains for abnormal grain growth, only a limited number of abnormal grains were generated in the PZT polycrystalline body, and the seed single crystal of Ba(Ti_{0.7}Zr_{0.3})O₃ continued to be grown into the PZT polycrystalline body. At this time, the growth rate of single crystal was about 100 µm/h.

When the abnormal grain growth was induced by adding excess PbO to the PZT powder and controlling the Zr/Ti ratio, and the average size of matrix grains of the polycrystalline body was continuously changed, it was possible to control the average size of matrix grains to be slightly larger than the critical size (R_{c} in Fig. 1) of matrix grains for abnormal grain growth in the PZT polycrystalline body having a specific Zr/Ti ratio. Based on a method that the size of matrix grains is controlled by changing the component ratio of matrix grains of a polycrystalline body, the abnormal grain growth was controlled in the PZT polycrystalline body. Under the above conditions, the abnormal grain growth was repressed inside the PZT polycrystalline body, but the seed single crystal of Ba(Ti_{0.7}Zr_{0.3})O₃ continued to be grown into the PZT polycrystalline body at the interface between the seed single crystal of Ba(Ti_{0.7}Zr_{0.3})O₃ and the PZT polycrystalline body with a mechanism such as an abnormal grain growth through a heat treatment, thereby producing a big PZT single crystal inside the PZT polycrystalline body. In this Example, the range of the average size of matrix grains, in which the seed single crystal could be grown, was 0.5R_{c} ≤ R ≤ 2R_{c}. (R_{c} is the critical size of matrix grains for abnormal grain growth.)

### < Example 8>

In this Example, single crystals of (1-*x*-*y*)Pb(Mg_{1/3}Nb_{2/3})O₃-*x*PbTiO₃-*y*PbZrO₃ [(1-*x*-*y*)PMN-*x*PT-*y*PZ], (1-*x*-*y*)Pb(Yb_{1/2}Nb_{1/2})O₃-*x*PbTiO₃-*y*PbZrO₃ [(1-*x*-*y*)PYbN-*x*PT-*y*PZ], (1-*x*-*y*)Pb(In_{1/2}Nb_{1/2})O₃-*x*Pb(Mg_{1/3}Nb_{2/3})O₃-*y*PbTiO₃ [(1-*x*-*y*)PIN-*x*PMN-*y*PT] and materials which have a difficulty in production by a general Liquid-State Single Crystal Growth method because they have complicated compositions and a difficulty in controlling the melting and the single crystal growth mechanism were prepared by a Solid-State Crystal Growth method. In particular, since the single crystals of (1-*x*-*y*)PMN-*x*PT-*y*PZ, (1-*x*-*y*)PYbN-*x*PT-*y*PZ and (1-*x*-*y*)PIN-*x*PMN-*y*PT have a Curie temperature higher than that of the existing PMN-PT single crystals, it is possible to manufacture and use them at high temperatures. Accordingly, it is required to develop them for commercializing the piezoelectric single crystals at room and high temperatures. In this Example, (1-*x-y*)PNM-*x*PT-*y*PZ, (1-*x-y*)PYbN-*x*PT-*y*PZ and (1-*x-y*)PIN-*x*PMN-*y*PT powders were prepared by the Columbite precursor method as in Example 6. In mixing the powders, powders having various compositions were prepared by controlling the ratios of lead oxide, niobium oxide, magnesium carbonate hydroxide, titanium dioxide and oxides of raw materials. The powder-molded bodies were prepared by uniaxial pressure molding, and then were subject to cold isostatic pressing at the pressure of 200 MPa. They were sintered on a platinum (Pt) plate in a double platinum crucible, and atmospheric powders such as lead zirconate (PbZrO₃[PZ]) and PbO powders were placed around the sample to repress the volatilization of PbO during sintering.

The powder-molded bodies were prepared by adding excess PbO of 30 mol% or less to (1-*x-y*)PMN-*x*PT-*y*PZ, (1-*x-y*)PYbN-*x*PT-*y*PZ and (1-*x-y*)PIN-*x*PN4N-*y*PT powders, and then they were sintered. In the microstructure thereof, an abnormal grain growth occurred in the samples with excess PbO added thereto, and the size of matrix grains was increased and the number density of abnormal grains was decreased as the amount of excess PbO was increased. Accordingly, when excess PbO more than a specific amount was added to the powders, it was possible to control the average size of matrix grains to be slightly larger than the critical size (R_{c} in Fig. 1) of matrix grains for abnormal grain growth, and to continue to grow the seed single crystal of Ba(Ti_{0.95}Zr_{0.05})O₃.

Fig. 11 is a photograph showing a surface of a sample obtained by embedding a seed single crystal of Ba(Ti_{0.95}Zr_{0.05})O₃ in a powder-molded body which was prepared by adding excess PbO of 9 mol% to the powder having the composition formula of (50)[Pb(Mg_{1/3}Nb_{2/3})O₃]-(36)[PbTiO₃]-(14)[PbZrO₃] (50PMN-36PT-14PZ) and then heat-treating the combination at 1200°C for 100 hours. During the heat treatment, a single crystal of 50PMN-36PT-14PZ continued to be grown from the seed single crystal of Ba(Ti_{0.95}Zr_{0.05})O₃ in the powder-molded body to the surface of the sintered body. As shown in Fig. 11, when the powder-molded body was subject to heat-treating at 1200°C for 100 hours, it was possible to produce the single crystal of 50PMN-36PT-14PZ having a size of 2 cm or more.

When the powder-molded body having the composition formula of (50)[Pb(Mg_{1/3}Nb_{2/3})O₃]-(36)[PbTiO₃]-(14)[PbZrO₃] with excess PbO of 6 mol% added thereto was subject to heat treating at 1200°C, the size of matrix grains was so small that the number density of abnormal grains was high. When the size of matrix grains was increased by primarily sintering the sample at 1250°C for 5 hours, the abnormal grain growth did not occur in the polycrystalline body. However, the seed single crystal of Ba(Ti_{0.95}Zr_{0.05})O₃ continued to be grown, and thus it was possible to produce a single crystal of 50PMN-36PT-14PZ having a size of 2 cm or more.

Fig. 12 is a photograph showing a surface of a sample obtained by embedding a seed single crystal of Ba(Ti_{0.95}Zr_{0.05})O₃ in a powder-molded body which was prepared by adding excess PbO of 8 mol% to the powder having the composition formula of (50)[Pb(Yb_{1/2}Nb_{1/2})O₃]-(36)[PbTiO₃]-(14)[PbZrO₃] (50PYbN-36PT-14PZ) and then heat-treating the combination at 1150°C for 100 hours. During the heat treatment, a single crystal of 50PYbN-36PT-14PZ continued to be grown from the seed single crystal of Ba(Ti_{0.95}Zr_{0.05})O₃ in the powder-molded body to the surface of the sintered body. As shown in Fig. 12, when the powder-molded body was subject to heat-treating at 1200°C for 100 hours, it was possible to produce the single crystal of 50PYbN-36PT-14PZ having a size of 2 cm or more.

Fig. 13 is a photograph showing a surface of a sample obtained by embedding a seed single crystal of Ba(Ti_{0.95}Zr_{0.05})O₃ in a powder-molded body which was prepared by adding excess PbO of 9 mol% to the powder having the composition formula of (20)[Pb(In_{1/2}Nb_{1/2})O₃]-(48)[Pb(Mg_{1/3}Nb_{2/3})O₃]-(32)[PbTiO₃] (20PIN-48PMN-32PT) and then heat-treating the combination at 1200°C for 100 hours. During the heat treatment, a single crystal of 20PIN-48PMN-32PT continued to be grown from the seed single crystal of Ba(Ti_{0.95}Zr_{0.05})O₃ in the powder-molded body to the surface of the sintered body. As shown in Fig. 13, when the powder-molded body was subject to heat-treating at 1200°C for 100 hours, it was possible to produce the single crystal of 20PIN-48PMN-32PT having a size of 2 cm or more.

This Example made it possible to produce various single crystals of (1-x-y)Pb(Mg_{1/3}Nb_{2/3})O₃-*x*PbTiO₃-*y*PbZrO₃ [(1-*x*-*y*)PMN-*x*PT-*y*PZ], (1-x-y)Pb(Yb_{1/2}Nb_{1/2})O₃-*x*PbTiO₃-*y*PbZrO₃ [(1-*x-y*)PYbN-*x*PT-*y*PZ], (1-x-y)Pb(In_{1/2}Nb_{1/2})O₃-*x*Pb(Mg_{1/3}Nb_{2/3})O₃-*y*PbTiO₃ [(1*-x-y*)PIN-*x*PMN-*y*PT] (0≤x≤1; 0≤y≤1; 0≤x+y≤1), and Pb-type perovskite oxide solid solution through Solid-State Single Crystal Growth, thereby providing a method for growing single crystals capable of producing piezoelectric single crystals having a high Curie temperature in large quantities at low costs, which are generally difficult to be manufactured.

### <Example 9>

In this Example, a single crystal having the composition of solid solution with solute substances non-uniformly dispersed therein was prepared according to the method of the invention. In the Example 1, the single crystal and polycrystalline body of barium titanate solid solution prepared by uniformly dispersing and mixing BaCO₃, TiO₂ and ZrO₂ powders and having uniformly dispersed zirconia (ZrO₂) therein were produced. In this Example, in order to prepare a single crystal with solute substances non-uniformly dispersed therein, firstly, a polycrystalline body of solid solution with solute substances non-uniformly dispersed therein were prepared by preparing barium titanate powders comprising the respective solute substances, and depositing them in regular order in a mold. As the additives to be used for preparing a single crystal of barium titanate solid solution having the composition formula of ((100-*x*)BaTiO₃-(x)MO [mol%]), one or more additives selected from the group consisting of Bi₂O₃, CaO, CdO, CeO₂, CoO, Cr₂O₃, Fe₂O₃, HfO₂, K₂O, La₂O₃, MgO, MnO₂, Na₂O, Nb₂O₃, Nd₂O₃, NiO, PbO, Sc₂O₃, SmO₂, SnO₂, SrO, Ta₂O₅, UO₂, Y₂O₃, ZnO, and ZrO₂ which are known to be solid-solutioned into barium titanate are added to the polycrystalline body. A disc-type powder-molded body having a diameter of 15 mm and a height of 7 mm was prepared with 2.5g powder prepared by mixing barium titanate and the powder of additive (MO) and having the composition formula of (100-*x*)BaTiO₃-(x)MO (mol%), and then was subject to cold isostatic pressing at the pressure of 200 MPa. As in the Example 2, the prepared solid solution powder-molded body was subject to heat-treating at the atmosphere of oxygen partial pressure of 0.01 or less to increase the size matrix grains of the polycrystalline body, and then was subject to heat-treating at 1360°C for 100 hours in the atmosphere of oxygen partial pressure of 0.2, thereby causing a single crystal having the composition of solid solution to be produced.

Fig. 14 is a photograph showing a cross-section of a sample obtained by depositing powders having the composition formulas of (99.8)BaTiO₃-(0.2)MnO₂, (99.8)BaTiO₃-(0.2)NbO_{2.5} and (99.8)BaTiO₃-(0.2)CeO₂ [mol%] in regular order, respectively, primarily sintering the molded body at 1370°C for 5 hours in the atmosphere of oxygen partial pressure of 0.01, placing a seed single crystal of barium titanate on the sintered body, and then heat-treating the combination of the seed single crystal and the sintered body at 1370°C for 100 hours in the atmosphere of oxygen partial pressure of 0.2. As in the Example 2, the matrix grain growth was promoted in the polycrystalline body of barium titanate solid solution when the polycrystalline body had been sintered in the atmosphere of oxygen partial pressure (Pₒ₂) of 0.01. However, the abnormal grain growth did not occur even if the polycrystalline body was again subject to heat-treating in the atmosphere of oxygen partial pressure (Pₒ₂) of 0.2. When the seed single crystal of barium titanate was placed on the polycrystalline body having a composition gradient and sintered in the atmosphere of oxygen partial pressure of 0.01 (i.e., the sintered body prepared by depositing powders having the compositions formulas of (99.9)BaTiO₃-(0.2)MnO₂, (99.9)BaTiO₃-(0.2)NbO_{2.5}, and (99.9)BaTiO₃-(0.2)CeO₂ [mol%] in regular order), and the combination of the seed single crystal and the polycrystalline body was subject to heat-treating at 1370°C for 100 hours in the atmosphere of oxygen partial pressure of 0.2, the seed single crystal was firstly grown into a portion comprising MnO₂, and then continued to be grown a portion comprising NbO_{2.5} and CeO₂. In this manner, a single crystal of barium titanate solid solution having a discontinuous composition gradient and consisting of non-doped barium titanate, Mn solid solution, Nb solid solution and Ce solid solution was obtained. When the size of matrix grains of the polycrystalline body having the composition of solid solution was controlled by controlling the atmosphere, it was possible to continuously grow the seed single crystal into the polycrystalline body and to produce a single crystal having the composition of solid solution and a size of several tens mm and a single crystal of solid solution compositions having a composition gradient. It is clearly advantageous to produce a single crystal having a composition gradient, which is difficult to be produced by a general Liquid-State Single Crystal Growth method due to the composition gradient therein.

### <Example 10>

A single crystal to be grown from a seed single crystal in the polycrystalline body has the same crystallographic orientation as the seed single crystal, and when defects are included in the seed single crystal, the growing single crystal also comprises the same defects. In this Example, based on this theory, it was shown that a single crystal having a desired specific crystallographic orientation and a single crystal comprising desired specific defects (for example, single twin, double twin, grain boundary, etc.) could be easily produced by grinding a specific crystal face of a seed single crystal in the crystallographic orientation, and then adjoining the ground seed single crystal to the polycrystalline body, or adjoining a seed single crystal having specific defects to the polycrystalline body. In this Example, the polycrystalline body of barium titanate with excess ZrO₂ added thereto having the composition formula of (99.6)BaTiO₃-(0.4)ZrO₂ was used as in the Example 2.

Figs. 15a and 15b are photographs showing samples obtained by placing (a) a single crystal of barium titanate comprising a (111) double twin and (b) two rod-type single crystals of barium titanate which were turned by an angle of about 10° after separating one rod single crystal into two single crystals, on the powder-molded body having the composition formula of (99.6)BaTiO₃-(0.4)ZrO₂, and then heat-treating the combination at 1380°C for 200 hours. As shown in Fig. 15, when (a) the single crystal comprising (111) double twin and (b) the rod-type single crystals which were turned by about 10° were used, the single crystal grown from the seed single crystal had also the same defects as those of the seed single crystal. When the single crystals comprising defects such as a (111) double twin and low angle grain boundaries are desired to be produced as in this Example, it was shown that it was possible to produce the single crystals comprising desired defects if the seed single crystal comprising desired defects was produced. In particular, it is possible to produce bicrystals with specific crystallographic orientations by simultaneously using at least two single crystals and by use of the seed single crystal comprising the same defects.

As described above, the method for growing single crystals according to the present invention has some advantages to provide a manufacturing process for single crystals such as single crystals of undoped barium titanate, single crystals of barium titanate solid solution, PZT single crystals, PZT single crystals of solid solution, PMN-PT single crystal, and PMN-PT single crystals of solid solution by using a general and simple heat treatment method without special equipments or skilled functions, as a result of which a large amount of single crystals large enough for practical uses of more than several cm can be produced at a low cost. This method for growing single crystals according to the present invention allows a growth of single crystals without a limitation in the size of the single crystal and provides high reproducibility of the single crystals with a composition gradient. The method also makes it possible to control the porosity of the single crystal, and the size and shape of pores, and prepare a complex single crystal from a polycrystalline body of a desired shape adjoined to the seed single crystal by heat treatment without a complicate step of processing a single crystal. This method of the present invention is efficient in the economical aspect because the final single crystals can be reused as a seed single crystal to produce various seed single crystals at a low cost, and also applicable to other materials showing an abnormal grain growth as well as barium titanate (BaTiO₃) and Pb-type perovskite.

While the invention has been shown and described with reference to certain preferred embodiments thereof, it will be understood by those skilled in the art that various changes in form and details may be made therein without departing from the spirit and scope of the invention as defined by the appended claims.

## Claims

1. A method for growing solid-state single crystals of materials, which show abnormal grain growth by means of heat treatment, comprising:
(a) controlling an average size of matrix grains of a polycrystalline body of the materials, thereby reducing a number density of abnormal grains (number of abnormal grains/unit area); and
(b) heat-treating the polycrystalline body having reduced number density of abnormal grains through the (a), thereby growing the abnormal grains, wherein the average size (R) of matrix grains of the polycrystalline body is controlled to be within a range between 0.5R_{c} and 2R_{c} (i.e., 0.5R_{c} ≤ R ≤ 2R_{c}), the R_{c} being a critical size of the matrix grains at which the nucleation of abnormal grains in the polycrystalline body begins and an average size of the matrix grains at which the number density of abnormal grains becomes zero, and
wherein the polycrystalline body is selected from the group consisting of (1-*x*)[Pb(Mg_{1/3}Nb_{2/3})O₃]-*x*[PbTiO₃] (0≤x≤1) (PMN-PT); PMN-PT solid solution; Pb(ZrₓTi₁₋ₓ)O₃ (0≤x≤1) (PZT); PZT solid solution (((Pbₓ,M₁₋ₓ)(ZrₐTi_{b}N_{c})O₃ (0≤x≤1; 0≤a, b, c≤1; a+b+c=1))); (1*-x-y*)[Pb(Mg_{1/3}Nb_{2/3})O₃]-*x*[PbTiO₃]-*y*[PbZrO₃] (0≤x≤1; 0≤y≤1; 0≤x+y≤ 1) (PMN-PT-PZ); PMN-PT-PZ solid solution; (1-*x-y*)[Pb(Yb_{1/2}Nb_{1/2})O₃]-*x*[PbTiO₃]-*y*[PbZrO₃] (0≤x≤1; 0≤y≤1; 0≤x+y≤1) (PYbN-PT-PZ); PYbN-PT-PZ solid solution; (1*-x-y*)[Pb(In_{1/2}Nb_{1/2})O₃]-*x*[PbTiO₃]-*y*[PbZrO₃] (0≤x≤1; 0≤y≤1; 0≤x+y≤1) (PIN-PT-PZ); PIN-PT-PZ solid solution; (1-*x-y*)[Pb(Mg_{1/3}Nb_{2/3})O₃]-*x*[Pb(Yb_{1/2}Nb_{1/2})O₃]-*y*[PbTiO₃] (0≤x≤1; 0≤y≤1; 0≤x+y≤1) (PMN-PYbN-PT); PMN-PYbN-PT solid solution; (1*-x-y*)[Pb(Mg_{1/3}Nb_{2/3})O₃]-*x*[Pb(In_{1/2}Nb_{1/2})O₃]-*y*[PbTiO₃] (0≤x≤1; 0≤y≤1; 0≤x+y≤1) (PMN-PIN-PT); and PMN-PIN-PT solid solution.

2. The method according to any of Claim 1, wherein the single crystals are obtained by continuing to grow only a limited number of abnormal grains produced under the state that the number density of abnormal grains of the polycrystalline body is reduced.

3. The method according to any of Claim 1 to 2, further comprising: prior to the heat-treatment, adjoining a seed single crystal to the polycrystalline body, and then continuing to grow the seed single crystal into the polycrystalline body during the heat-treatment.

4. The method according to any of Claim 1 to 3, wherein the average size (R) of matrix grains of the polycrystalline body is controlled to be within a range between 0.5R_{c} and R_{c} (i.e., 0.5R_{c} ≤ R≤ R_{c}).

5. The method according to any of Claim 1 to 4, wherein the abnormal grain growth is a secondary abnormal grain growth.

6. The method according to any of Claim 1 to 5, wherein the average size of matrix grains of the polycrystalline body is controlled by adding one or more specific components among components of matrix grains of the polycrystalline body in amounts higher or lower than the original composition of the polycrystalline body.

7. The method according to any of Claim 1 to 6, wherein the average size of matrix grains of the polycrystalline body is controlled by changing a ratio of components of matrix grains of the polycrystalline body.

8. The method according to any of Claim 1 to 7, wherein the average size of matrix grains of the polycrystalline body is controlled by adding one or more additives different from the components of matrix grains of the polycrystalline body to the polycrystalline body.

9. The method according to any of Claim 1 to 8, wherein, the control of average size of matrix grains of the polycrystalline body is carried out at a temperature higher than the heat treatment temperature to increase the average size of matrix grains of the polycrystalline body.

10. The method according to any of Claim 1 to 9, wherein the average size of matrix grains of the polycrystalline body is controlled by using sintering atmosphere different from that of the heat treatment.

11. The method according to Claim 10, wherein, the average size of matrix grains of the polycrystalline body is controlled by using reductive sintering atmosphere.

12. The method according to any of Claim 1 to 11, wherein, the average size of matrix grains of the polycrystalline body is increased by repeatedly inducing abnormal grain growth in the polycrystalline body.

13. The method according to any of Claim 3 to 12, wherein the heat treatment is carried out under the condition that additives for promoting abnormal grain growth are locally added at the interface between the seed single crystal and the polycrystalline body.

14. The method according to any of Claim 3 to 13, wherein the seed single crystal comprises defects such as a single twin boundary, a double twin boundary and a low angle grain boundary, thereby producing a single crystal comprising the same defects as those of the seed single crystal.

15. The method according to any of Claim 3 to 14, wherein the polycrystalline body is powder-molded or processed to a desired shape, and the shaped or processed polycrystalline body is adjoined to the seed single crystal, thereby producing a single crystal having the desired shape without a separate step for processing the single crystal.
